# EUROPEAN PATENT APPLICATION

(11) **EP 4 282 841 A1**
(43) Date of publication of application: **29.11.2023**
(21) Application number: 22742442.1
(22) Date of filing: 07.01.2022
(51) Int. Cl.: C03C 17/30, C09D 5/16, C08K 5/16, C09D 183/00, C09K 3/00, C09K 3/18, C08L 71/00, C09D 7/63

(54) **SURFACE TREATMENT AGENT**

(30) Priority: 19.01.2021 JP 2021006477
(71) Applicant: Daikin Industries, Ltd., Osaka-shi, Osaka 530-0001 (JP)
(72) Inventor: NAITO, Masato, Osaka-shi, Osaka 530-8323 (JP); TORTISSIER, Gregory, Osaka-shi, Osaka 530-8323 (JP); OMUKAI, Yoshikage, Osaka-shi, Osaka 530-8323 (JP); HANDA, Shinya, Osaka-shi, Osaka 530-8323 (JP); NOMURA, Takashi, Osaka-shi, Osaka 530-8323 (JP)
(74) Representative: Hoffmann Eitle
(86) International application number: PCT/JP2022/000394
(87) International publication number: WO 2022/158319

(57) **Abstract**

The present invention relates to a surface-treating agent comprising a fluoropolyether group-containing silane compound and an amide compound, wherein the amide compound is contained in an amount of 0.5% by mass or more based on a total amount of the surface-treating agent.

## Description

### Technical Field

The present disclosure relates to a surface-treating agent and an article having a layer formed of the surface-treating agent.

### Background Art

Certain types of fluoropolyether group-containing silane compounds are known to be capable of providing excellent water-repellency, oil-repellency, antifouling properties, and the like when used in surface treatment of a substrate. A layer obtained from a surface-treating agent containing a fluoropolyether group-containing silane compound (hereinafter, also referred to as a "surface-treating layer") is applied as a so-called functional thin film to a large variety of substrates such as glass, plastics, fibers, sanitary articles, and building materials (Patent Literature 1).

### Prior Art Literature

### Patent Literature

Patent Literature 1: JP 2014-218639 A

### Summary of Invention

### Technical Problem

The fluoropolyether group-containing silane compound described in Patent Literature 1 can provide a surface-treating layer having an excellent function, but a surface-treating layer having higher abrasion durability is required.

An object of the present disclosure is to provide an article having a surface-treating layer having higher abrasion durability.

### Solution to Problem

The present disclosure includes the following embodiments.
[1] A surface-treating agent comprising a fluoropolyether group-containing silane compound and an amide compound, wherein the amide compound is contained in an amount of 0.5% by mass or more based on a total amount of the surface-treating agent.
[2] The surface-treating agent according to [1], wherein the fluoropolyether group-containing silane compound is at least one fluoropolyether group-containing silane compound represented by the following formula (1) or (2):

   R^{F1}_{α} - X^{A} - R^{Si}_{β} (1)

   R^{Si}_{γ} - X^{A} - R^{F2}- X^{A} -R^{Si}_{γ} (2)

   wherein
   R^{F1} is each independently at each occurrence Rf¹-R^{F}-O_{q}-;
   R^{F2} is -Rf²ₚ-R^{F}-O_{q}-;
   Rf¹ is each independently at each occurrence a C₁₋₁₆ alkyl group optionally substituted with one or more fluorine atoms;
   Rf² is a C₁₋₆ alkylene group optionally substituted with one or more fluorine atoms;
   R^{F} is each independently at each occurrence a divalent fluoropolyether group;
   p is 0 or 1;
   q is each independently at each occurrence 0 or 1;
   R^{Si} is each independently at each occurrence a monovalent group containing a Si atom to which a hydroxyl group, a hydrolyzable group, a hydrogen atom, or a monovalent organic group is bonded;
   at least one R^{Si} is a monovalent group containing a Si atom to which a hydroxyl group or a hydrolyzable group is bonded;
   X^{A} is each independently a single bond or a di- to decavalent organic group;
   α is an integer of 1 to 9;
   β is an integer of 1 to 9; and
   γ is each independently an integer of 1 to 9.
[3] The surface-treating agent according to [2], wherein Rf¹ is each independently at each occurrence a C₁₋₁₆ perfluoroalkyl group; and
   Rf² is each independently at each occurrence a C₁₋₆ perfluoroalkylene group.
[4] The surface-treating agent according to [2] or [3], wherein R^{F} is each independently at each occurrence a group represented by the formula:

   ⁻ (OC₆F₁₂)ₐ-(OC₅F₁₀)_{b}-(OC₄F₈)_{c}-(OC₃R^{Fa}₆)_{d}-(OC₂F₄)e-(OCF₂)_{f}-

   wherein R^{Fa} is each independently at each occurrence a hydrogen atom, a fluorine atom, or a chlorine atom; and
   a, b, c, d, e, and f are each independently an integer of 0 to 200, the sum of a, b, c, d, e, and f is 1 or more, the occurrence order of the respective repeating units enclosed in parentheses provided with a, b, c, d, e, or f is not limited in the formula, provided that when all R^{Fa} are a hydrogen atom or a chlorine atom, at least one of a, b, c, e, and f is 1 or more.
[5] The surface-treating agent according to [4], wherein R^{Fa} is a fluorine atom.
[6] The surface-treating agent according to any one of [2] to [5], wherein R^{F} is each independently at each occurrence a group represented by the following formula (f1), (f2), (f3), (f4), or (f5) :

   -(OC₃F₆)_{d}-(OC₂F₄)ₑ- (f1)

   wherein d is an integer of 1 to 200, and e is 0 or 1;

   -(OC₄F₈)_{c}-(OC₃F₆)_{d}-(OC₂F₄)ₑ-(OCF₂)_{f}- (f2)

   wherein c and d are each independently an integer of 0 to 30;
   e and f are each independently an integer of 1 to 200;
   the sum of c, d, e, and f is an integer of 10 to 200; and
   the occurrence order of the respective repeating units enclosed in parentheses provided with the subscript c, d, e, or f is not limited in the formula;

      -(R⁶-R⁷)_{g}- (f3)

      wherein R⁶ is OCF₂ or OC₂F₄;
   R⁷ is a group selected from OC₂F₄, OC₃F₆, OC₄F₈, OC₅F₁₀, and OC₆F₁₂, or is a combination of two or three groups selected from these groups; and
   g is an integer of 2 to 100;

      -(OC₆F₁₂)ₐ-(OC₅F₁₀)_{b}-(OC₄F₈)_{c}-(OC₃F₆)_{d}-(OC₂F₄)ₑ-(OCF₂)_{f}- (f4)

      wherein e is an integer of 1 or more and 200 or less, a, b, c, d, and f are each independently an integer of 0 or more and 200 or less, and the occurrence order of the respective repeating units enclosed in parentheses provided with a, b, c, d, e or f is not limited in the formula; and

      -(OC₆F₁₂)ₐ-(OC₅F₁₀)_{b}-(OC₄F₈)_{c}-(OC₃F₆)_{d}-(OC₂F₄)ₑ-(OCF₂)_{f}- (f5)

      wherein f is an integer of 1 or more and 200 or less, a, b, c, d, and e are each independently an integer of 0 or more and 200 or less, and the occurrence order of the respective repeating units enclosed in parentheses provided with a, b, c, d, e or f is not limited in the formula.
[7] The surface-treating agent according to any one of [2] to [6], wherein R^{Si} is a group represented by the following formula (S1), (S2), (S3), (S4), or (S5):

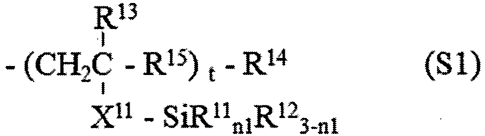

   - Si¹¹ₙ₁R¹²₃₋ₙ₁ (S2)

   - SiR^{a1}ₖ₁R^{b1}₁₁R^{c1}m₁ (S3)

   - CR^{d1}ₖ₂R^{e1}ₗ₂R^{f1}ₘ₂ (S4)

   - NR^{g1}R^{h1} (S5)

   wherein
   R¹¹ is each independently at each occurrence a hydroxyl group or a hydrolyzable group;
   R¹² is each independently at each occurrence a hydrogen atom or a monovalent organic group;
   n1 is each independently an integer of 0 to 3 for each (SiR¹¹ₙ₁R¹²₃₋ₙ₁) unit;
   X¹¹ is each independently at each occurrence a single bond or a divalent organic group;
   R¹³ is each independently at each occurrence a hydrogen atom or a monovalent organic group;
   t is each independently at each occurrence an integer of 2 or more;
   R¹⁴ is each independently at each occurrence a hydrogen atom, a halogen atom, or -X¹¹-SiR¹¹ₙ₁R¹²₃₋ₙ₁;
   R^{a1} is each independently at each occurrence -Z¹-SiR²¹p₁R²²q₁R²³ᵣ₁;
   Z¹ is each independently at each occurrence an oxygen atom or a divalent organic group;
   R²¹ is each independently at each occurrence -Z^{1'}-SiR^{21'}ₚ₁'R^{22'}_{q1}R^{23'}_{r1'};
   R²² is each independently at each occurrence a hydroxyl group or a hydrolyzable group;
   R²³ is each independently at each occurrence a hydrogen atom or a monovalent organic group;
   p1 is each independently at each occurrence an integer of 0 to 3;
   q1 is each independently at each occurrence an integer of 0 to 3;
   r1 is each independently at each occurrence an integer of 0 to 3;
   the sum of p1, q1, and r1 is 3;
   Z^{1'} is each independently at each occurrence an oxygen atom or a divalent organic group;
   R^{21'} is each independently at each occurrence -Z¹"-SiR^{22"}q_{1"}R^{23"}_{r1"};
   R^{22'} is each independently at each occurrence a hydroxyl group or a hydrolyzable group;
   R^{23'} is each independently at each occurrence a hydrogen atom or a monovalent organic group;
   p1' is each independently at each occurrence an integer of 0 to 3;
   q1' is each independently at each occurrence an integer of 0 to 3;
   r1' is each independently at each occurrence an integer of 0 to 3;
   the sum of p1', q1', and r1' is 3;
   Z^{1"} is each independently at each occurrence an oxygen atom or a divalent organic group;
   R^{22"} is each independently at each occurrence a hydroxyl group or a hydrolyzable group;
   R^{23"} is each independently at each occurrence a hydrogen atom or a monovalent organic group;
   q1" is each independently at each occurrence an integer of 0 to 3;
   r1" is each independently at each occurrence an integer of 0 to 3;
   the sum of q1" and r1" is 3;
   R^{b1} is each independently at each occurrence a hydroxyl group or a hydrolyzable group;
   R^{c1} is each independently at each occurrence a hydrogen atom or a monovalent organic group;
   k1 is each independently at each occurrence an integer of 0 to 3;
   11 is each independently at each occurrence an integer of 0 to 3;
   m1 is each independently at each occurrence an integer of 0 to 3;
   the sum of k1, 11, and m1 is 3;
   R^{d1} is each independently at each occurrence -Z²-CR³¹ₚ₂R³²_{q2}R³³ᵣ₂;
   Z² is each independently at each occurrence a single bond, an oxygen atom, or a divalent organic group;
   R³¹ is each independently at each occurrence -Z^{2'}-CR^{32'}q_{2'}R^{33'}_{r2'};
   R³² is each independently at each occurrence -Z³-SiR³⁴ₙ₂R³⁵₃₋ₙ₂;
   R³³ is each independently at each occurrence a hydrogen atom, a hydroxyl group, or a monovalent organic group;
   p2 is each independently at each occurrence an integer of 0 to 3;
   q2 is each independently at each occurrence an integer of 0 to 3;
   r2 is each independently at each occurrence an integer of 0 to 3;
   the sum of p2, q2, and r2 is 3;
   Z^{2'} is each independently at each occurrence a single bond, an oxygen atom, or a divalent organic group;
   R^{32'} is each independently at each occurrence -Z³-SiR³⁴ₙ₂R³⁵₃₋ₙ₂;
   R³³' is each independently at each occurrence a hydrogen atom, a hydroxyl group, or a monovalent organic group;
   q2' is each independently at each occurrence an integer of 0 to 3;
   r2' is each independently at each occurrence an integer of 0 to 3;
   the sum of q2' and r2' is 3;
   Z³ is each independently at each occurrence a single bond, an oxygen atom, or a divalent organic group;
   R³⁴ is each independently at each occurrence a hydroxyl group or a hydrolyzable group;
   R³⁵ is each independently at each occurrence a hydrogen atom or a monovalent organic group;
   n2 is each independently at each occurrence an integer of 0 to 3;
   R^{e1} is each independently at each occurrence -Z³-SiR³⁴ₙ₂R³⁵₃₋ₙ₂;
   R^{f1} is each independently at each occurrence a hydrogen atom, a hydroxyl group, or a monovalent organic group;
   k2 is each independently at each occurrence an integer of 0 to 3;
   12 is each independently at each occurrence an integer of 0 to 3;
   m2 is each independently at each occurrence an integer of 0 to 3;
   the sum of k2, 12, and m2 is 3;
   R^{g1} and R^{h1} are each independently at each occurrence - Z⁴-SiR¹¹ₙ₁R¹²₃₋ₙ₁, -Z⁴-SiR^{a1}ₖ₁R^{b1}ₗ₁R^{c1}ₘ₁, or -Z⁴-CR^{d1}ₖ₂R^{e1}ₗ₂R^{f1}ₘ₂; and
   Z⁴ is each independently at each occurrence a single bond, an oxygen atom, or a divalent organic group,
   provided that in the formulae (S1), (S2), (S3), (S4), and (S5), at least one Si atom to which a hydroxyl group or a hydrolyzable group is bonded is present.
[8] The surface-treating agent according to any one of [2] to [7], wherein each of α, β and γ is 1.
[9] The surface-treating agent according to [7] or [8] wherein the group represented by the formula (S1) is a group represented by the following formula (S1-b): 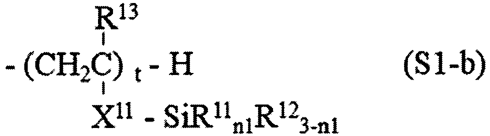 wherein R¹¹, R¹², R¹³, X¹¹, n1, and t have the same definition as described for the formula (S1).
[10] The surface-treating agent according to any one of [1] to [9], wherein a content of the amide compound is 0.5 to 10.0% by mass based on the total amount of the surface-treating agent.
[11] The surface-treating agent according to any one of [1] to [10], wherein a boiling point of the amide compound under atmospheric pressure is 150 to 300°C.
[12] The surface-treating agent according to any one of [1] to [11], wherein the amide compound is an amide compound represented by the following formula (A):

   NR⁶¹R⁶²-COR⁶³ (A)

   wherein
   R⁶¹ is a hydrogen atom or a C₁₋₁₀ alkyl group;
   R⁶² is a C₁₋₁₀ alkyl group;
   R⁶³ is a hydrogen atom, a C₁₋₁₀ alkyl group, NR⁶⁵₂, or - R⁶⁶ₓ-R⁶⁷_{y}-R⁶⁸;
   or, R⁶² and R⁶³ are bonded to each other to form -R⁶²-R⁶³-, wherein -R⁶²-R⁶³- is a C₃₋₄ alkylene group or -C₂₋₃ alkylene-NR⁶⁵-;
   R⁶⁵ is each independently a hydrogen atom or a C₁₋₁₀ alkyl group;
   R⁶⁶ is each independently at each occurrence a C₁₋₆ alkylene group;
   R⁶⁷ is an oxygen atom or CO;
   R⁶⁸ is a C₁₋₁₀ alkyl group;
   x is an integer of 1 to 6; and
   y is an integer of 1 to 6,
   with the proviso that each occurrence order of R⁶⁶ and R⁶⁷ in -R⁶⁶ₓ-R⁶⁷_{y}-R⁶⁸ is not limited.
[13] The surface-treating agent according to [12], wherein R⁶³ is -R⁶⁶ₓ-R⁶⁷_{y}-R⁶⁸.
[14] The surface-treating agent according to [12], wherein R⁶³ is -R⁶⁶-R⁶⁷-R⁶⁶-R⁶⁸.
[15] The surface-treating agent according to [12], wherein R⁶² and R⁶³ are bonded to each other to form -R⁶²-R⁶³-, where -R⁶²-R⁶³- is a C₃₋₄ alkylene group.
[16] The surface-treating agent according to any one of [1] to [15], further comprising one or more other components selected from a fluorine-containing oil, a silicone oil, and a catalyst.
[17] The surface-treating agent according to any one of [1] to [16], further comprising a solvent.
[18] The surface-treating agent according to any one of [1] to [17], which is used as an antifouling coating agent or a water-proof coating agent.
[19] A pellet comprising the surface-treating agent according to any one of [1] to [17].
[20] An article comprising a substrate and a layer on the substrate, the layer being formed of the surface-treating agent according to any one of [1] to [18].
[21] The article according to [20], wherein the substrate is a glass substrate.
[22] The article according to [20], which is an optical member.

### Advantageous Effects of Invention

According to the present disclosure, it is possible to provide a surface-treating agent capable of providing a surface-treating layer having higher abrasion durability.

### Brief Description of Drawing

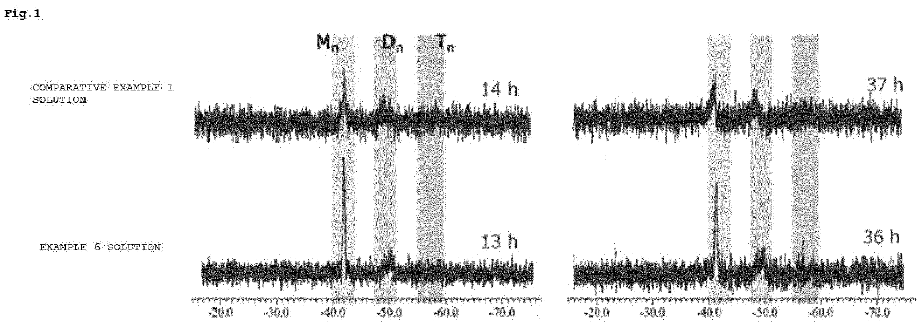

Figure 1 shows the results of a stability test in Examples.

### Description of Embodiments

The term "monovalent organic group", as used herein, refers to a monovalent group containing carbon. The monovalent organic group is not limited, and may be a hydrocarbon group or a derivative thereof. The derivative of the hydrocarbon group refers to a group that has one or more of N, O, S, Si, amide, sulfonyl, siloxane, carbonyl, carbonyloxy, and the like at the end or in the molecular chain of the hydrocarbon group. The simple term "organic group" refers to a monovalent organic group. The term "di-to decavalent organic group" means a di- to decavalent group containing a carbon. The di- to decavalent organic group may be, but is not limited to, a di- to decavalent group obtained by further removing 1 to 9 hydrogen atoms from an organic group. The divalent organic group is not limited, and examples thereof include divalent groups obtained by further removing one hydrogen atom from an organic group.

The term "hydrocarbon group", as used herein, refers to a group that contains carbon and hydrogen and that is obtained by removing one hydrogen atom from a hydrocarbon. The hydrocarbon group is not limited, and examples thereof include a C₁₋₂₀ hydrocarbon group optionally substituted with one or more substituents, such as an aliphatic hydrocarbon group and an aromatic hydrocarbon group. The above "aliphatic hydrocarbon group" may be either linear, branched, or cyclic, and may be either saturated or unsaturated. The hydrocarbon group may contain one or more ring structures.

Each substituent of the "hydrocarbon group", as used herein, is not limited, and examples thereof include a halogen atom; and one or more groups selected from a C₁₋₆ alkyl group, a C₂₋₆ alkenyl group, a C₂₋₆ alkynyl group, a C₃-₁₀ cycloalkyl group, a C₃₋₁₀ unsaturated cycloalkyl group, a 5- to 10-membered heterocyclyl group, a 5- to 10-membered unsaturated heterocyclyl group, a C₆₋₁₀ aryl group, and a 5-to 10-membered heteroaryl group, each of which is optionally substituted with one or more halogen atoms.

The term "hydrolyzable group", as used herein, means a group which can undergo a hydrolysis reaction, namely, means a group which can be removed from a main backbone of the compound by a hydrolysis reaction. Examples of the hydrolyzable group include -OR^{j}, -OCOR^{j}, -O-N=CR^{j}₂, -NR^{j}₂, - NHR^{j}, -NCO, and halogen (in these formulae, R^{j} represents a substituted or unsubstituted C₁₋₄ alkyl group).

The surface-treating agent of the present disclosure contains a fluoropolyether group-containing silane compound and an amide compound.

The surface-treating agent of the present disclosure can provide a surface-treating layer having improved friction resistance by further containing an amide compound in addition to the fluoropolyether group-containing silane compound.

### (Fluoropolyether group-containing silane compound)

The fluoropolyether group-containing silane compound is a compound that contains fluorine and can form a surface-treating layer having antifouling properties.

In one embodiment, the fluoropolyether group-containing silane compound is at least one fluoropolyether group-containing silane compound represented by the following formula (1) or (2):

R^{F1}_{α}-X^{A}-R^{Si}_{β} (1)

R^{Si}_{γ}-X^{A}-R^{F2}-X^{A}-R^{Si}_{γ} (2)

wherein
R^{F1} is each independently at each occurrence Rf¹-R^{F}-O_{q}-;
R^{F2} is -Rf²ₚ-R^{F}-O_{q}-;
Rf¹ is each independently at each occurrence a C₁₋₁₆ alkyl group optionally substituted with one or more fluorine atoms;
Rf² is a C₁₋₆ alkylene group optionally substituted with one or more fluorine atoms;
R^{F} is each independently at each occurrence a divalent fluoropolyether group;
p is 0 or 1;
q is each independently at each occurrence 0 or 1;
R^{Si} is each independently at each occurrence a monovalent group containing a Si atom to which a hydroxyl group, a hydrolyzable group, a hydrogen atom, or a monovalent organic group is bonded;
at least one R^{Si} is a monovalent group containing a Si atom to which a hydroxyl group or a hydrolyzable group is bonded;
X^{A} is each independently a single bond or a di- to decavalent organic group;
α is an integer of 1 to 9;
β is an integer of 1 to 9; and
γ is each independently an integer of 1 to 9.

In the formula (1), R^{F1} is each independently at each occurrence Rf¹-R^{F}-O_{q}-.

In the formula (2), R^{F2} is -Rf²ₚ-R^{F}-O_{q}-.

In the formula, Rf¹ is each independently at each occurrence a C₁₋₁₆ alkyl group optionally substituted with one or more fluorine atoms.

In the C₁₋₁₆ alkyl group optionally substituted with one or more fluorine atoms, the "C₁₋₁₆ alkyl group" may be linear or branched, and is preferably a linear or branched C₁₋₆ alkyl group, in particular C₁₋₃ alkyl group, and more preferably a linear C₁₋₆ alkyl group, in particular C₁₋₃ alkyl group.

Rf¹ is preferably a C₁₋₁₆ alkyl group substituted with one or more fluorine atoms, more preferably a CF₂H-C₁₋₁₅ perfluoroalkylene group, still more preferably a C₁₋₁₆ perfluoroalkyl group.

The C₁₋₁₆ perfluoroalkyl group may be linear or branched, and is preferably a linear or branched C₁₋₆ perfluoroalkyl group, in particular C₁₋₃ perfluoroalkyl group, more preferably a linear C₁₋₆ perfluoroalkyl group, in particular C₁₋₃ perfluoroalkyl group, and specifically -CF₃, -CF₂CF₃, or -CF₂CF₂CF₃.

In the formula, Rf² is a C₁₋₆ alkylene group optionally substituted with one or more fluorine atoms.

In the C₁₋₆ alkylene group optionally substituted with one or more fluorine atoms, the "C₁₋₆ alkylene group" may be linear or branched, and is preferably a linear or branched C₁₋₃ alkylene group, and more preferably a linear C₁₋₃ alkylene group.

Rf² is preferably a C₁₋₆ alkylene group that is substituted with one or more fluorine atoms, more preferably a C₁₋₆ perfluoroalkylene group, and still more preferably a C₁₋₃ perfluoroalkylene group.

The C₁₋₆ perfluoroalkylene group may be linear or branched, and is preferably a linear or branched C₁₋₃ perfluoroalkylene group, more preferably a linear C₁₋₃ perfluoroalkylene group, and specifically -CF₂-, -CF₂CF₂-, or -CF₂CF₂CF₂-.

In the formula, p is 0 or 1. In one embodiment, p is 0. In another embodiment, p is 1.

In the formulae, q is each independently at each occurrence 0 or 1. In one embodiment, q is 0. In another embodiment, q is 1.

In the formulae (1) and (2), R^{F} is each independently at each occurrence a divalent fluoropolyether group.

R^{F} is preferably a group represented by the formula:

- (OC₆F₁₂)ₐ-(OC₅F₁₀)_{b}-(OC₄F₈)_{c}-(OC₃R^{Fa}₆)_{d}-(OC₂F₄)ₑ-(OCF₂)_{f}-

wherein
R^{Fa} is each independently at each occurrence a hydrogen atom, a fluorine atom, or a chlorine atom;
a, b, c, d, e, and f are each independently an integer of 0 to 200, and the sum of a, b, c, d, e, and f is 1 or more; and the occurrence order of the respective repeating units enclosed in parentheses provided with a, b, c, d, e, or f is not limited in the formula, provided that when all R^{Fa} are a hydrogen atom or a chlorine atom, at least one of a, b, c, e, and f is 1 or more.

R^{Fa} is preferably a hydrogen atom or a fluorine atom, and more preferably a fluorine atom. However, when all R^{Fa} are a hydrogen atom or a chlorine atom, at least one of a, b, c, e, and f is 1 or more.

Preferably, a, b, c, d, e, and f are each independently an integer of 0 to 100.

The sum of a, b, c, d, e, and f is preferably 5 or more, and more preferably 10 or more, and may be, for example, 15 or more or 20 or more. The sum of a, b, c, d, e, and f is preferably 200 or less, more preferably 100 or less, and still more preferably 60 or less, and may be, for example, 50 or less or 30 or less.

These repeating units may be linear or branched. For example, -(OC₆F₁₂)- may be -(OCF₂CF₂CF₂CF₂CF₂CF₂)-, - (OCF(CF₃)CF₂CF₂CF₂CF₂)-, -(OCF₂CF(CF₃)CF₂CF₂CF₂)-, - (OCF₂CF₂CF(CF₃)CF₂CF₂)-, -(OCF₂CF₂CF₂CF(CF₃)CF₂)-, - (OCF₂CF₂CF₂CF₂CF(CF₃))-, or the like. -(OC₅F₁₀)- may be - (OCF₂CF₂CF₂CF₂CF₂)-, - (OCF(CF₃)CF₂CF₂CF₂)-, - (OCF₂CF(CF₃)CF₂CF₂)-, -(OCF₂CF₂CF(CF₃)CF₂)-, - (OCF₂CF₂CF₂CF(CF₃))-, or the like. (OC₄F₈)- may be any of - (OCF₂CF₂CF₂CF₂)-, -(OCF(CF₃)CF₂CF₂)-, -(OCF₂CF(CF₃)CF₂)-, - (OCF₂CF₂CF(CF₃))-, -(OC(CF₃)₂CF₂)-, -(OCF₂C(CF₃)₂)-, - (OCF(CF₃)CF(CF₃))-, -(OCF(C₂F₅)CF₂)-, and -(OCF₂CF(C₂F₅))-. - (OC₃F₆)- (that is, in the formula, R^{Fa} is a fluorine atom) may be any of -(OCF₂CF₂CF₂)-, - (OCF (CF₃)CF₂)-, and - (OCF₂CF(CF₃)) -. -(OC₂F₄)- may be any of -(OCF₂CF₂)- and - (OCF (CF₃)) -.

In one embodiment, the above repeating units are linear. When the repeating units are linear, the surface lubricity, abrasion durability, and the like of the surface-treating layer can be improved.

In one embodiment, the above repeating units are branched. When the above repeating units are branched, the dynamic friction coefficient of the surface-treating layer can be increased.

In one embodiment, R^{F} is each independently at each occurrence a group represented by any of the following formulae (f1) to (f5):

- (OC₃F₆)_{d}-(OC₂F₄)ₑ- (f1)

wherein d is an integer of 1 to 200, and e is 0 or 1;

- (OC₄F₈)_{c}-(OC₃F₆)_{d}-(OC₂F₄)ₑ-(OCF_{2 f}- (f2)

wherein c and d are each independently an integer of 0 or more and 30 or less, and e and f are each independently an integer of 1 or more and 200 or less;
the sum of c, d, e, and f is 2 or more; and
the occurrence order of the respective repeating units enclosed in parentheses provided with the subscript c, d, e, or f is not limited in the formula;

   - (R⁶-R⁷)_{g}- (f3)

   wherein R⁶ is OCF₂ or OC₂F₄;
R⁷ is a group selected from OC₂F₄, OC₃F₆, OC₄F₈, OC₅F₁₀, and OC₆F₁₂, or alternatively a combination of two or three groups independently selected from these groups; and
g is an integer of 2 to 100;

   - (OC₆F₁₂)ₐ-(OC₅F₁₀)_{b}-(OC₄F₈)_{c}-(OC₃F₆)_{d}-(OC₂F₄)ₑ-(OCF_{2 f}- (f4)

   wherein e is an integer of 1 or more and 200 or less, a, b, c, d, and f are each independently an integer of 0 or more and 200 or less, and the occurrence order of the respective repeating units enclosed in parentheses provided with a, b, c, d, e or f is not limited in the formula; and

   - (OC₆F₁₂)ₐ-(OC₅F₁₀)_{b}-(OC₄F₈)_{c}-(OC₃F₆)_{d}-(OC₂F₄)ₑ-(OCF_{2 f}- (f5)

   wherein f is an integer of 1 or more and 200 or less, a, b, c, d, and e are each independently an integer of 0 or more and 200 or less, and the occurrence order of the respective repeating units enclosed in parentheses provided with a, b, c, d, e or f is not limited in the formula.

In the formula (f1), d is preferably 5 to 200, more preferably 10 to 100, and still more preferably 15 to 50, and is, for example, an integer of 25 to 35. In one embodiment, e is 1. In another embodiment, e is 0. In the formula (f1), OC₃F₆ is preferably OCF₂CF₂CF₂, OCF₂CF(CF₃), or OCF(CF₃)CF₂, and more preferably OCF₂CF₂CF₂.

In the formula (f2), e and f are each independently an integer of preferably 5 to 200, and more preferably 10 to 200. In addition, the sum of c, d, e, and f is preferably 5 or more, and more preferably 10 or more, and it may be, for example, 15 or more or 20 or more. In one embodiment, the formula (f2) is preferably a group represented by - (OCF₂CF₂CF₂CF₂)_{c}-(OCF₂CF₂CF₂)_{d}-(OCF₂CF₂)ₑ-(OCF_{2 f}-. In another embodiment, the formula (f2) may be a group represented by - (OC₂F₄)ₑ-(OCF_{2 f}-.

In the formula (f3), R⁶ is preferably OC₂F₄. In the formula (f3), R⁷ is preferably a group selected from OC₂F₄, OC₃F₆, and OC₄F₈, or a combination of two or three groups independently selected from these groups, and is more preferably a group selected from OC₃F₆ and OC₄F₈. Examples of the combination of two or three groups independently selected from OC₂F₄, OC₃F₆, and OC₄F₈ are not limited, but include -OC₂F₄OC₃F₆-, -OC₂F₄OC₄F₆-, -OC₃F₆OC₂F₄-, -OC₃F₆OC₃F₆-, - OC₃F₆OC₄F₆-, -OC₄F₈OC₄F₈—, -OC₄F₈OC₃F₆-, -OC₄F₈OC₂F₄-, - OC₂F₄OC₂F₄OC₃F₆-, -OC₂F₄OC₂F₄OC₄F₈-, -OC₂F₄OC₃F₆OC₂F₄-, - OC₂F₄OC₃F₆OC₃F₆-, -OC₂F₄OC₄F₈OC₂F₄-, -OC₃F₆OC₂F₄OC₂F₄-, - OC₃F₆OC₂F₄OC₃F₆-, -OC₃F₆OC₃F₆OC₂F₄-, and -OC₄F₈OC₂F₄OC₂F₄-. In the formula (f3), g is an integer of preferably 3 or more, and more preferably 5 or more. g is preferably an integer of 50 or less. In the formula (f3), OC₂F₄, OC₃F₆, OC₄F₈, OC₅F₁₀, and OC₆F₁₂ may be either linear or branched, and they are preferably linear. In this embodiment, the formula (f3) is preferably -(OC₂F₄-OC₃F₆)_{g}- or -(OC₂F₄-OC₄F₈)_{g}-.

In the formula (f4), e is an integer of preferably 1 or more and 100 or less, and more preferably 5 or more and 100 or less. The sum of a, b, c, d, e, and f is preferably 5 or more, and more preferably 10 or more, and is, for example, 10 or more and 100 or less.

In the formula (f5), f is an integer of preferably 1 or more and 100 or less, and more preferably 5 or more and 100 or less. The sum of a, b, c, d, e, and f is preferably 5 or more, and more preferably 10 or more, and is, for example, 10 or more and 100 or less.

In one embodiment, R^{F} is a group represented by the formula (f1).

In one embodiment, R^{F} is a group represented by the formula (f2).

In one embodiment, R^{F} is a group represented by the formula (f3).

In one embodiment, R^{F} is a group represented by the formula (f4).

In one embodiment, R^{F} is a group represented by the formula (f5).

In R^{F}, the ratio of e to f (hereinafter, referred to as an "e/f ratio") is 0.1 to 10, preferably 0.2 to 5, more preferably 0.2 to 2, still more preferably 0.2 to 1.5, and further preferably 0.2 to 0.85. With an e/f ratio of 10 or less, the lubricity, abrasion durability, and chemical resistance (such as durability against artificial sweat) of a surface-treating layer obtained from the compound are further improved. The lower the e/f ratio is, the more improved the lubricity and the abrasion durability of the surface-treating layer are. On the other hand, with an e/f ratio of 0.1 or more, the stability of the compound can be further enhanced. The larger the e/f ratio is, the more improved the stability of the compound is.

In one embodiment, the e/f ratio is preferably 0.2 to 0.95, and more preferably 0.2 to 0.9.

In one embodiment, from the viewpoint of heat resistance, the e/f ratio is preferably 1.0 or more, and more preferably 1.0 to 2.0.

In the fluoropolyether group-containing silane compound, the number average molecular weight of the R^{F1} and R^{F2} moieties is not limited, and is, for example, 500 to 30,000, preferably 1,500 to 30,000, and more preferably 2,000 to 10,000. Herein, the number average molecular weight of R^{F1} and R^{F2} is defined as a value obtained by ¹⁹F-NMR measurement.

In another embodiment, the number average molecular weight of the R^{F1} and R^{F2} moieties is 500 to 30,000, preferably 1,000 to 20,000, more preferably 2,000 to 15,000, and still more preferably 2,000 to 10,000, and may be, for example, 3,000 to 6,000.

In another embodiment, the number average molecular weight of the R^{F1} and R^{F2} moieties may be 4,000 to 30,000, preferably 5,000 to 10,000, and more preferably 6,000 to 10,000.

In the formulae (1) and (2), R^{Si} is each independently at each occurrence a monovalent group containing a Si atom to which a hydroxyl group, a hydrolyzable group, a hydrogen atom, or a monovalent organic group is bonded, and at least one R^{Si} is a monovalent group containing a Si atom to which a hydroxyl group or a hydrolyzable group is bonded.

Here, the term "hydrolyzable group" means a group which can undergo a hydrolysis reaction, namely, means a group which can be removed from a main backbone of the compound by a hydrolysis reaction. Examples of the hydrolyzable group include -_{OR}^{j}, -OCOR^{j}, -O-N=CR^{j}₂, -NR^{j}₂, -NHR^{j}, -NCO, and halogen (in these formulae, R^{j} represents a substituted or unsubstituted C₁₋₄ alkyl group).

In a preferred embodiment, R^{Si} is a monovalent group containing a Si atom to which a hydroxyl group or a hydrolyzable group is bonded.

In a preferred embodiment, R^{Si} is a group represented by the following formula (S1), (S2), (S3), or (S4):

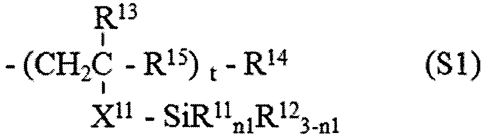

- SiR¹¹ₙ₁R¹²₃₋ₙ₁ (S2)

- SiR^{a1}ₖ₁R^{b1}ₗ₁R^{c1}ₘ₁ (S3)

- CR^{d1}ₖ₂R^{e1}ₗ₂R^{f1}ₘ₂ (S4)

- NR^{g1}R^{h1} (S5)

In the above formula, R¹¹ is each independently at each occurrence a hydroxyl group or a hydrolyzable group.

Preferably, R¹¹ is each independently at each occurrence a hydrolyzable group.

R¹¹ is each independently at each occurrence preferably -_{OR}^{j}, -OCOR^{j}, -O-N=CR^{j}₂, -NR^{j}₂, -NHR^{j}, -NCO, or a halogen (wherein R^{j} represents a substituted or unsubstituted C₁₋₄ alkyl group), more preferably -OR^{j} (i.e. alkoxy group). Examples of R^{j} include unsubstituted alkyl groups such as a methyl group, an ethyl group, a propyl group, an isopropyl group, a n-butyl group, and an isobutyl group; and substituted alkyl groups such as a chloromethyl group. Of them, an alkyl group, particularly an unsubstituted alkyl group, is preferable, and a methyl group or an ethyl group is more preferable. In one embodiment, R^{j} is a methyl group, and in another embodiment, R^{j} is an ethyl group.

In the formula, R¹² is each independently at each occurrence a hydrogen atom or a monovalent organic group. Such a monovalent organic group is a monovalent organic group excluding the above hydrolyzable group.

In R¹², the monovalent organic group is preferably a C₁-₂₀ alkyl group, more preferably a C₁₋₆ alkyl group, and still more preferably a methyl group.

In the formula, n1 is each independently an integer of 0 to 3 for each (SiR¹¹ₙ₁R¹²₃₋ₙ₁) unit. However, in a case where R^{Si} is a group represented by the formula (S1) or (S2), at least one (SiR¹¹ₙ₁R¹²₃₋ₙ₁) unit in which n1 is 1 to 3 is present in the end R^{Si} moieties of the formula (1) and the formula (2) (hereinafter, also simply referred to as "ends" of the formula (1) and the formula (2)). That is, in such ends, not all n1 are 0 at the same time. In other words, in the ends of the formula (1) and the formula (2), at least one Si atom to which the hydroxyl group or the hydrolyzable group is bonded is present.

n1 is each independently an integer of preferably 1 to 3, more preferably 2 to 3, still more preferably 3 for each (SiR¹¹ₙ₁R¹²₃₋ₙ₁) unit.

In the formula, X¹¹ is each independently at each occurrence a single bond or a divalent organic group. Such a divalent organic group is preferably -R²⁸-Oₓ-R²⁹-, wherein R²⁸ and R²⁹ are each independently at each occurrence a single bond or a C₁₋₂₀ alkylene group, and x is 0 or 1. Such a C₁₋₂₀ alkylene group may be linear or branched, but is preferably linear. Such a C₁₋₂₀ alkylene group is preferably a C₁₋₁₀ alkylene group, more preferably a C₁₋₆ alkylene group, and still more preferably a C₁₋₃ alkylene group.

In one embodiment, X¹¹ is each independently at each occurrence -C₁₋₆ alkylene-O-C₁₋₆ alkylene- or -O-C₁₋₆ alkylene-.

In a preferable embodiment, X¹¹ is each independently at each occurrence a single bond or a linear C₁₋₆ alkylene group, preferably a single bond or a linear C₁₋₃ alkylene group, more preferably a single bond or a linear C₁₋₂ alkylene group, and still more preferably a linear C₁₋₂ alkylene group.

In the formula, R¹³ is each independently at each occurrence a hydrogen atom or a monovalent organic group. Such a monovalent organic group is preferably a C₁₋₂₀ alkyl group. Such a C₁₋₂₀ alkyl group may be linear or branched, but is preferably linear.

In a preferred embodiment, R¹³ is each independently at each occurrence a hydrogen atom or a linear C₁₋₆ alkyl group, preferably a hydrogen atom or a linear C₁₋₃ alkyl group, preferably a hydrogen atom or a methyl group.

In the above formula, t is each independently at each occurrence an integer of 2 or more.

In a preferable embodiment, t is each independently at each occurrence an integer of 2 to 10, preferably an integer of 2 to 6.

In the formula, R¹⁴ is each independently at each occurrence a hydrogen atom, a halogen atom, or -X¹¹-SiR¹¹ₙ₁R¹²₃-ₙ₁. Such a halogen atom is preferably an iodine atom, a chlorine atom, or a fluorine atom, and more preferably a fluorine atom. In a preferred embodiment, R¹⁴ is a hydrogen atom.

In one embodiment, the formula (S1) is the following formula (S1-a): 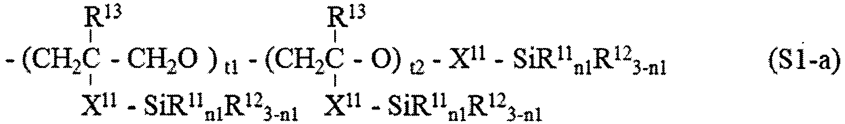 wherein
R¹¹, R¹², R¹³, X¹¹, and n1 have the same definition as described for the formula (S1);
t1 and t2 are each independently at each occurrence an integer of 1 or more, preferably an integer of 1 to 10, more preferably an integer of 2 to 10, for example, an integer of 1 to 5 or an integer of 2 to 5; and
the occurrence order of each repeating unit, which is enclosed in parenthesis provided with t1 and t2, is not limited in the formula.

In a preferred embodiment, the formula (S1) is the following formula (S1-b): 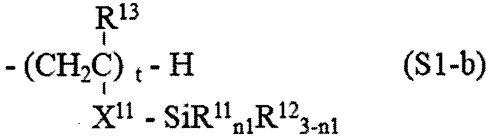 wherein R¹¹, R¹², R¹³, X¹¹, n1, and t have the same definition as described for the formula (S1).

In the formula, R^{a1} is each independently at each occurrence -Z¹-SiR²¹ₚ₁R²²_{q1}R²³ᵣ₁.

Z¹ is each independently at each occurrence an oxygen atom or a divalent organic group. The structure denoted as Z¹ hereinafter is bonded to (SiR²¹ₚ₁R²²_{q1}R²³ᵣ₁) on the right side.

In a preferred embodiment, Z¹ is a divalent organic group.

In a preferred embodiment, Z¹ does not include a group that forms a siloxane bond with a Si atom to which Z¹ is bonded. Preferably, in the formula (S3), (Si-Z¹-Si) does not contain a siloxane bond.

Z¹ is preferably a C₁₋₆ alkylene group, - (CH₂)_{z1}-O-(CH₂)_{z2}-(wherein z1 is an integer of 0 to 6; for example, an integer of 1 to 6, and z2 is an integer of 0 to 6; for example, an integer of 1 to 6) or, - (CH₂)_{z3}-phenylene- (CH₂)_{z4}- (wherein z3 is an integer of 0 to 6; for example, an integer of 1 to 6, and z4 is an integer of 0 to 6; for example, an integer of 1 to 6) . Such a C₁₋₆ alkylene group may be linear or branched, and is preferably linear. These groups may be substituted with, for example, one or more substituents selected from a fluorine atom, a C₁₋₆ alkyl group, a C₂₋₆ alkenyl group, and a C₂₋₆ alkynyl group, but are preferably unsubstituted.

In a preferred embodiment, Z¹ is a C₁₋₆ alkylene group or - (CH₂)_{z3}-phenylene- (CH₂)_{z4}-, and preferably -phenylene-(CH₂)_{z4}-. When Z¹ is such a group, light resistance, in particular ultraviolet resistance, can be further enhanced.

In another preferred embodiment, Z¹ is a C₁₋₃ alkylene group. In one embodiment, Z¹ may be -CH₂CH₂CH₂-. In another embodiment, Z¹ may be -CH₂CH₂-.

R²¹ is each independently at each occurrence -Z^{1'}-SiR^{21'}ₚ₁'R^{22'}_{q1'}R^{23'}_{r1'}.

Z^{1'} is each independently at each occurrence an oxygen atom or a divalent organic group. The structure denoted as Z^{1'} hereinafter is bonded to (SiR^{21'}_{p1'}R^{22'}_{q1'}R^{23'}_{r1'}) on the right side.

In a preferred embodiment, Z^{1'} is a divalent organic group.

In a preferred embodiment, Z^{1'} does not include a group that forms a siloxane bond with a Si atom to which Z^{1'} is bonded. Preferably, in the formula (S3), (Si-Z^{1'}--Si) does not contain a siloxane bond.

Z^{1'} is preferably a C₁₋₆ alkylene group, - (CH₂)_{z1'}-O-(CH₂)_{z2'}- (wherein z1' is an integer of 0 to 6; for example, an integer of 1 to 6, and z2' is an integer of 0 to 6; for example, an integer of 1 to 6), or -(CH₂)_{z3'}-phenylene-(CH₂)_{z4'}- (wherein z3' is an integer of 0 to 6; for example, an integer of 1 to 6, z4' is an integer of 0 to 6; for example, an integer of 1 to 6) . Such a C₁₋₆ alkylene group may be linear or branched, and is preferably linear. These groups may be substituted with, for example, one or more substituents selected from a fluorine atom, a C₁₋₆ alkyl group, a C₂₋₆ alkenyl group, and a C₂₋₆ alkynyl group, but are preferably unsubstituted.

In a preferred embodiment, Z^{1'} is a C₁₋₆ alkylene group or - (CH₂)_{z3'}-phenylene-(CH₂)_{z4'}-, preferably -phenylene-(CH₂)_{z4'}-. When Z^{1'} is such a group, light resistance, in particular ultraviolet resistance, can be further enhanced.

In another preferred embodiment, Z^{1'} is a C₁₋₃ alkylene group. In one embodiment, Z^{1'} may be -CH₂CH₂CH₂-. In another embodiment, Z^{1'} may be -CH₂CH₂-.

R^{21'} is each independently at each occurrence -Z^{1"}-SiR^{22"}q_{1"}R^{23"}_{r1"}.

Z¹" is each independently at each occurrence an oxygen atom or a divalent organic group. The structure denoted as Z¹" hereinafter is bonded to (SiR^{22"}_{q1"}R^{23"}_{r1"}) on the right side.

In a preferred embodiment, Z^{1"} is a divalent organic group.

In a preferred embodiment, Z^{1"} does not include a group that forms a siloxane bond with a Si atom to which Z^{1"} is bonded. Preferably, in the formula (S3), (Si-Z^{1"}-Si) does not contain a siloxane bond.

Z^{1"} is preferably a C₁₋₆ alkylene group, - (CH₂)_{z1"}-O-(CH₂)_{z2"}- (wherein z1" is an integer of 0 to 6; for example, an integer of 1 to 6, and z2" is an integer of 0 to 6; for example, an integer of 1 to 6), or - (CH₂)_{z3"}-phenylene-(CH₂)_{z4"}- (wherein z3" is an integer of 0 to 6; for example, 1 to 6, z4" is an integer of 0 to 6; for example, an integer of 1 to 6). Such a C₁₋₆ alkylene group may be linear or branched, and is preferably linear. These groups may be substituted with, for example, one or more substituents selected from a fluorine atom, a C₁₋₆ alkyl group, a C₂₋₆ alkenyl group, and a C₂₋₆ alkynyl group, but are preferably unsubstituted.

In a preferred embodiment, Z^{1"} is a C₁₋₆ alkylene group or - (CH₂)_{z3"}-phenylene- (CH₂)_{z4"}-, preferably -phenylene-(CH₂)_{z4"}-. When Z^{1"} is such a group, light resistance, in particular ultraviolet resistance, can be further enhanced.

In another preferred embodiment, Z^{1"} is a C₁₋₃ alkylene group. In one embodiment, Z^{1"} may be -CH₂CH₂CH₂-. In another embodiment, Z^{1"} may be -CH₂CH₂-.

R^{22"} is each independently at each occurrence a hydroxyl group or a hydrolyzable group.

Preferably, R^{22"} is each independently at each occurrence a hydrolyzable group.

R^{22"} is each independently at each occurrence preferably -_{OR}^{j}, -OCOR^{j}, -O-N=CR^{j}₂, -NR^{j}₂, -NHR^{j}, -NCO, or a halogen (wherein R^{j} represents a substituted or unsubstituted C₁₋₄ alkyl group), more preferably -OR^{j} (i.e. alkoxy group). Examples of R^{j} include unsubstituted alkyl groups such as a methyl group, an ethyl group, a propyl group, an isopropyl group, a n-butyl group, and an isobutyl group; and substituted alkyl groups such as a chloromethyl group. Of them, an alkyl group, particularly an unsubstituted alkyl group, is preferable, and a methyl group or an ethyl group is more preferable. In one embodiment, R^{j} is a methyl group, and in another embodiment, R^{j} is an ethyl group.

R^{23"} is each independently at each occurrence a hydrogen atom or a monovalent organic group. Such a monovalent organic group is a monovalent organic group excluding the above hydrolyzable group.

In R^{23"}, the monovalent organic group is preferably a C₁₋₂₀ alkyl group, more preferably a C₁₋₆ alkyl group, still more preferably a methyl group.

q1" is each independently at each occurrence an integer of 0 to 3, and r1" is each independently at each occurrence an integer of 0 to 3. The sum of q1" and r1" is 3 in the (SiR^{22"}_{q1"R}^{23"}_{r1"}) unit.

q1" is each independently an integer of preferably 1 to 3, more preferably 2 to 3, still more preferably 3 for each (SiR^{22"} _{q1"}R^{23"}_{r1"}) unit.

R^{22'} is each independently at each occurrence a hydroxyl group or a hydrolyzable group.

Preferably, R^{22'} is each independently at each occurrence a hydrolyzable group.

R^{22'} is each independently at each occurrence preferably -OR^{j}, -OCOR^{j}, -O-N=CR^{j}₂, -NR^{j}₂, -NHR^{j}, -NCO, or a halogen (wherein R^{j} represents a substituted or unsubstituted C₁₋₄ alkyl group), more preferably -OR^{j} (i.e. alkoxy group). Examples of R^{j} include unsubstituted alkyl groups such as a methyl group, an ethyl group, a propyl group, an isopropyl group, a n-butyl group, and an isobutyl group; and substituted alkyl groups such as a chloromethyl group. Of them, an alkyl group, particularly an unsubstituted alkyl group, is preferable, and a methyl group or an ethyl group is more preferable. In one embodiment, R^{j} is a methyl group, and in another embodiment, R^{j} is an ethyl group.

R^{23'} is each independently at each occurrence a hydrogen atom or a monovalent organic group. Such a monovalent organic group is a monovalent organic group excluding the above hydrolyzable group.

In R^{23'}, the monovalent organic group is preferably a C₁₋₂₀ alkyl group, more preferably a C₁₋₆ alkyl group, still more preferably a methyl group.

p1' is each independently at each occurrence an integer 0 to 3, q1' is each independently at each occurrence an integer of 0 to 3, and r1' is each independently at each occurrence an integer of 0 to 3. The sum of p', q1', and r1' is 3 in the (SiR^{21'}_{p1'}R^{22'}_{q1'}R^{23'}_{r1'}) unit.

In one embodiment, p1' is 0.

In one embodiment, p1' may be each independently an integer of 1 to 3, an integer of 2 to 3, or 3 for each (SiR^{21'}_{p1'}R^{22'}_{q1'}R^{23'}_{r1'}) unit. In a preferred embodiment, p1' is 3.

In one embodiment, q1' is each independently an integer of 1 to 3, preferably an integer of 2 to 3, more preferably 3 for each (SiR^{21'}_{p1'}R^{22'}_{q1}'R^{23'}_{r1'}) unit.

In one embodiment, p1' is 0, and q1' is each independently an integer of 1 to 3, preferably an integer of 2 to 3, more preferably 3 for each (SiR^{21'}_{p1'}R^{22'}_{q1'}R^{23'}_{r1'}) unit.

R²² is each independently at each occurrence a hydroxyl group or a hydrolyzable group.

Preferably, R²² is each independently at each occurrence a hydrolyzable group.

R²² is each independently at each occurrence preferably -_{OR}^{j}, -OCOR^{j}, -O-N=CR^{j}₂, -NR^{j}₂, -NHR^{j}, -NCO, or a halogen (wherein R^{j} represents a substituted or unsubstituted C₁₋₄ alkyl group), more preferably -OR^{j} (i.e. alkoxy group). Examples of R^{j} include unsubstituted alkyl groups such as a methyl group, an ethyl group, a propyl group, an isopropyl group, a n-butyl group, and an isobutyl group; and substituted alkyl groups such as a chloromethyl group. Of them, an alkyl group, particularly an unsubstituted alkyl group, is preferable, and a methyl group or an ethyl group is more preferable. In one embodiment, R^{j} is a methyl group, and in another embodiment, R^{j} is an ethyl group.

R²³ is each independently at each occurrence a hydrogen atom or a monovalent organic group. Such a monovalent organic group is a monovalent organic group excluding the above hydrolyzable group.

In R²³, the monovalent organic group is preferably a C₁-₂₀ alkyl group, more preferably a C₁₋₆ alkyl group, and still more preferably a methyl group.

p1 is each independently at each occurrence an integer of 0 to 3, q1 is each independently at each occurrence an integer of 0 to 3, and r1 is each independently at each occurrence 0 to 3. The sum of p1, q1, and r1 is 3 in the (SiR²¹ₚ₁R²²_{q1}R²³ᵣ₁) unit.

In one embodiment, p1 is 0.

In one embodiment, p1 may be each independently an integer of 1 to 3, an integer of 2 to 3, or 3 for each (SiR²¹ₚ₁R²²_{q1}R²³ᵣ₁) unit. In a preferred embodiment, p1 is 3.

In one embodiment, q1 is each independently an integer of 1 to 3, preferably an integer of 2 to 3, more preferably 3 for each (SiR²¹ₚ₁R²²_{q1}R²³ᵣ₁) unit.

In one embodiment, p1 is 0, and q1 is each independently an integer of 1 to 3, preferably an integer of 2 to 3, still more preferably 3 for each (SiR²¹ₚ₁R²²_{q1}R²³ᵣ₁) unit.

In the formula, R^{b1} is each independently at each occurrence a hydroxyl group or a hydrolyzable group.

Preferably, R^{b1} is each independently at each occurrence a hydrolyzable group.

R^{b1} is each independently at each occurrence preferably -_{OR}^{j}, -OCOR^{j}, -O-N=CR^{j}₂, -NR^{j}₂, -NHR^{j}, -NCO, or a halogen (wherein R^{j} represents a substituted or unsubstituted C₁₋₄ alkyl group), more preferably -OR^{j} (i.e. alkoxy group). Examples of R^{j} include unsubstituted alkyl groups such as a methyl group, an ethyl group, a propyl group, an isopropyl group, a n-butyl group, and an isobutyl group; and substituted alkyl groups such as a chloromethyl group. Of them, an alkyl group, particularly an unsubstituted alkyl group, is preferable, and a methyl group or an ethyl group is more preferable. In one embodiment, R^{j} is a methyl group, and in another embodiment, R^{j} is an ethyl group.

In the formula, R^{c1} is each independently at each occurrence a hydrogen atom or a monovalent organic group. Such a monovalent organic group is a monovalent organic group excluding the above hydrolyzable group.

In R^{c1}, the monovalent organic group is preferably a C₁₋₂₀ alkyl group, more preferably a C₁₋₆ alkyl group, still more preferably a methyl group.

k1 is each independently at each occurrence an integer of 0 to 3, 11 is each independently at each occurrence an integer of 0 to 3, and m1 is each independently at each occurrence an integer of 0 to 3. The sum of k1, 11, and m1 is 3 in the (SiR^{a1}ₖ₁R^{b1}ₗ₁R^{e1}ₘ₁) unit.

In one embodiment, k1 is each independently an integer of 1 to 3, preferably an integer of 2 or 3, more preferably 3 for each (SiR^{a1}ₖ₁R^{b1}ₗ₁R^{e1}ₘ₁) unit. In a preferred embodiment, k1 is 3.

In the formulae (1) and (2), when R^{Si} is a group represented by the formula (S3), preferably, at least two Si atoms to which a hydroxyl group or a hydrolyzable group is bonded are present in the ends of the formulae (1) and (2).

In a preferred embodiment, the group represented by the formula (S3) has one of -Z¹-SiR²²_{q1}R^{z3}ᵣ₁ (wherein q1 is an integer of 1 to 3, preferably 2 or 3, more preferably 3, and r1 is an integer of 0 to 2), -Z^{1'}-SiR^{22'}_{q1'}R^{23'}_{r1'} (wherein q1' is an integer of 1 to 3, preferably 2 or 3, more preferably 3, and r1' is an integer of 0 to 2), and -Z^{1"}-SiR^{22"}_{q1"}R^{23"}_{r1"} (wherein q1" is an integer of 1 to 3, preferably 2 or 3, more preferably 3, and r1" is an integer of 0 to 2). Z¹, Z^{1'}, Z^{1"}, R²², R²³, R^{22'}, R^{23'}, R^{22"}, and R^{23"} have the same definition as above.

In a preferred embodiment, when R^{21'} is present in the formula (S3), q1" is an integer of 1 to 3, preferably 2 or 3, more preferably 3 in at least one, preferably all of R^{21'} groups.

In a preferred embodiment, when R²¹ is present in the formula (S3), p1' is 0, and q1' is an integer of 1 to 3, preferably 2 or 3, more preferably 3 in at least one, preferably all of R²¹ groups.

In a preferred embodiment, when R^{a1} is present in the formula (S3), p1 is 0, and q1 is an integer of 1 to 3, preferably 2 or 3, more preferably 3 in at least one, preferably all of R^{a1} groups.

In a preferred embodiment, in the formula (S3), k1 is 2 or 3, preferably 3, p1 is 0, q1 is 2 or 3, preferably 3.

R^{d1} is each independently at each occurrence -Z²-CR³¹ₚ₂R³²_{q2}R³³ᵣ₂.

Z² is each independently at each occurrence a single bond, an oxygen atom, or a divalent organic group. The structure denoted as Z² hereinafter is bonded to (CR³¹ₚ₂R³²_{q2}R³³ᵣ₂) on the right side.

In a preferred embodiment, Z² is a divalent organic group.

Z² is preferably a C₁₋₆ alkylene group, -(CH₂)_{z5}-O-(CH₂)_{z6}-(wherein z5 is an integer of 0 to 6; for example, an integer of 1 to 6, and z6 is an integer of 0 to 6; for example, an integer of 1 to 6), or -(CH₂)_{z7}-phenylene-(CH₂)_{z8}- (wherein z7 is an integer of 0 to 6; for example, an integer of 1 to 6, and z8 is an integer of 0 to 6; for example, an integer of 1 to 6) . Such a C₁₋₆ alkylene group may be linear or branched, and is preferably linear. These groups may be substituted with, for example, one or more substituents selected from a fluorine atom, a C₁₋₆ alkyl group, a C₂₋₆ alkenyl group, and a C₂₋₆ alkynyl group, but are preferably unsubstituted.

In a preferred embodiment, Z² is a C₁₋₆ alkylene group or - (CH₂)_{z7}-phenylene- (CH₂)_{z8}-, preferably -phenylene- (CH₂)_{z8}-. When Z² is such a group, light resistance, in particular ultraviolet resistance, can be further enhanced.

In another preferred embodiment, Z² is a C₁₋₃ alkylene group. In one embodiment, Z² may be -CH₂CH₂CH₂-. In another embodiment, Z² may be -CH₂CH₂-.

R³¹ is each independently at each occurrence -Z^{2'}-CR^{32'}_{q2'}R^{33'}_{r2'}.

Z^{2'} is each independently at each occurrence a single bond, an oxygen atom, or a divalent organic group. The structure denoted as Z^{2'} hereinafter is bonded to (CR^{32'}_{q2'}R^{33'}_{r2'}) on the right side.

Z^{2'} is preferably a C₁₋₆ alkylene group, - (CH₂)_{z5'}-O-(CH₂)_{z6'}- (wherein z5' is an integer of 0 to 6; for example, an integer of 1 to 6, and z6' is an integer of 0 to 6; for example, an integer of 1 to 6), or - (CH₂)_{z7'}-phenylene-(CH₂)_{zS'}- (wherein z7' is an integer of 0 to 6; for example, an integer of 1 to 6, and z8' is an integer of 0 to 6; for example, an integer of 1 to 6) . Such a C₁₋₆ alkylene group may be linear or branched, and is preferably linear. These groups may be substituted with, for example, one or more substituents selected from a fluorine atom, a C₁₋₆ alkyl group, a C₂₋₆ alkenyl group, and a C₂₋₆ alkynyl group, but are preferably unsubstituted.

In a preferred embodiment, Z^{2'} is a C₁₋₆ alkylene group or - (CH₂)_{z7'}-phenylene- (CH₂)_{z8'}-, preferably -phenylene-(CH₂)_{z8'}-. When Z^{2'} is such a group, light resistance, in particular ultraviolet resistance, can be further enhanced.

In another preferred embodiment, Z^{2'} is a C₁₋₃ alkylene group. In one embodiment, Z^{2'} may be -CH₂CH₂CH₂-. In another embodiment, Z^{2'} may be -CH₂CH₂-.

R^{32'} is each independently at each occurrence -Z³-SiR³⁴ₙ₂R³⁵₃₋ₙ₂.

Z³ is each independently at each occurrence a single bond, an oxygen atom or a divalent organic group. The structure denoted as Z³ hereinafter is bonded to (SiR³⁴ₙ₂R³⁵₃₋ₙ₂) on the right side.

In one embodiment, Z³ is an oxygen atom.

In one embodiment, Z³ is a divalent organic group.

Z³ is preferably a C₁₋₆ alkylene group, - (CH₂)_{z5"}-O-(CH₂)_{Z6"}- (wherein z5" is an integer of 0 to 6; for example, an integer of 1 to 6, and z6" is an integer of 0 to 6; for example, an integer of 1 to 6), or - (CH₂)_{z7"}-phenylene-(CH₂)_{Z8"}- (wherein z7" is an integer of 0 to 6; for example, an integer of 1 to 6, and z8" is an integer of 0 to 6; for example, an integer of 1 to 6). Such a C₁₋₆ alkylene group may be linear or branched, and is preferably linear. These groups may be substituted with, for example, one or more substituents selected from a fluorine atom, a C₁₋₆ alkyl group, a C₂₋₆ alkenyl group, and a C₂₋₆ alkynyl group, but are preferably unsubstituted.

In a preferred embodiment, Z³ is a C₁₋₆ alkylene group or - (CH₂)_{z7"}-phenylene- (CH₂)_{z8"}-, preferably -phenylene-(CH₂)_{z8"}-. When Z³ is such a group, light resistance, in particular ultraviolet resistance, can be further enhanced.

In another preferred embodiment, Z³ is a C₁₋₃ alkylene group. In one embodiment, Z³ may be -CH₂CH₂CH₂-. In another embodiment, Z³ may be -CH₂CH₂-.

R³⁴ is each independently at each occurrence a hydroxyl group or a hydrolyzable group.

Preferably, R³⁴ is each independently at each occurrence a hydrolyzable group.

R³⁴ is each independently at each occurrence preferably -_{OR}^{j}, -OCOR^{j}, -O-N=CR^{j}₂, -NR^{j}₂, -NHR^{j}, -NCO, or a halogen (wherein R^{j} represents a substituted or unsubstituted C₁₋₄ alkyl group), more preferably -OR^{j} (i.e. alkoxy group). Examples of R^{j} include unsubstituted alkyl groups such as a methyl group, an ethyl group, a propyl group, an isopropyl group, a n-butyl group, and an isobutyl group; and substituted alkyl groups such as a chloromethyl group. Of them, an alkyl group, particularly an unsubstituted alkyl group, is preferable, and a methyl group or an ethyl group is more preferable. In one embodiment, R^{j} is a methyl group, and in another embodiment, R^{j} is an ethyl group.

R³⁵ is each independently at each occurrence a hydrogen atom or a monovalent organic group. Such a monovalent organic group is a monovalent organic group excluding the above hydrolyzable group.

In R³⁵, the monovalent organic group is preferably a C₁₋₂₀ alkyl group, more preferably a C₁₋₆ alkyl group, still more preferably a methyl group.

In the formula, n2 is each independently an integer of 0 to 3 for each (SiR³⁴ₙ₂R³⁵₃₋ₙ₂) unit. However, in a case where R^{Si} is a group represented by the formula (S4), at least one (SiR³⁴ₙ₂R³⁵₃₋ₙ₂) unit with n2 of 1 to 3 is present in the ends of the formula (1) and the formula (2) . That is, in such ends, not all n2 are 0 at the same time. In other words, in the ends of the formula (1) and the formula (2), at least one Si atom to which the hydroxyl group or the hydrolyzable group is bonded is present.

n2 is each independently an integer of preferably 1 to 3, more preferably 2 to 3, still more preferably 3 for each (SiR³⁴ₙ₂R³⁵₃₋ₙ₂) unit.

R^{33'} is each independently at each occurrence a hydrogen atom, a hydroxyl group, or a monovalent organic group. Such a monovalent organic group is a monovalent organic group excluding the above hydrolyzable group.

In R^{33'}, the monovalent organic group is preferably a C₁₋₂₀ alkyl group or - (CsH₂ₛ)t₁-(O-CₛH₂s)t₂ (wherein s is an integer of 1 to 6, preferably an integer of 2 to 4, t1 is 1 or 0, preferably 0, and t2 is an integer of 1 to 20, preferably an integer of 2 to 10, more preferably an integer of 2 to 6), more preferably a C₁₋₂₀ alkyl group, more preferably a C₁₋₆ alkyl group, particularly preferably a methyl group.

In one embodiment, R^{33'} is a hydroxyl group.

In another embodiment, the monovalent organic group as R^{33'} is preferably a C₁₋₂₀ alkyl group, more preferably a C₁₋₆ alkyl group.

q2' is each independently at each occurrence an integer of 0 to 3, and r2' is each independently at each occurrence an integer of 0 to 3. The sum of q2' and r2' is 3 in the (CR^{32'}_{q2'}R^{33'}_{r2'}) unit.

q2' is each independently an integer of preferably 1 to 3, more preferably 2 to 3, still more preferably 3 for each (CR^{32'}_{q21}R^{33'}_{r2'}) unit.

R³² is each independently at each occurrence -Z³-SiR³⁴ₙ₂R³⁵₃₋ₙ₂. Such -Z³-SiR³⁴ₙ₂R³⁵₃₋ₙ₂ has the same definition as described in the above R^{32'}.

R³³ is each independently at each occurrence a hydrogen atom, a hydroxyl group, or a monovalent organic group. Such a monovalent organic group is a monovalent organic group excluding the above hydrolyzable group.

In R³³, the monovalent organic group is preferably a C₁-₂₀ alkyl group or -(CₛH₂ₛ)ₜ₁-(O-CₛH₂ₛ)ₜ₂ (wherein s is an integer of 1 to 6, preferably an integer of 2 to 4, t1 is 1 or 0, preferably 0, and t2 is an integer of 1 to 20, preferably an integer of 2 to 10, more preferably an integer of 2 to 6), more preferably a C₁₋₂₀ alkyl group, more preferably a C₁₋₆ alkyl group, particularly preferably a methyl group.

In one embodiment, R³³ is a hydroxyl group.

In another embodiment, the monovalent organic group as R³³ is preferably a C₁₋₂₀ alkyl group, more preferably a C₁₋₆ alkyl group.

p2 is each independently at each occurrence an integer of 0 to 3, q2 is each independently at each occurrence an integer of 0 to 3, and r2 is each independently at each occurrence an integer of 0 to 3. The sum of p2, q2, and r2 is 3 in the (CR³¹ₚ₂R³²_{q2}R³³ᵣ₂) unit.

In one embodiment, p2 is 0.

In one embodiment, p2 may be each independently an integer of 1 to 3, an integer of 2 to 3, or 3 for each (CR³¹ₚ₂R³²_{q2}R³³ᵣ₂) unit. In a preferred embodiment, p2 is 3.

In one embodiment, q2 is each independently an integer of 1 to 3, preferably an integer of 2 to 3, more preferably 3 for each (CR³¹ₚ₂R³²_{q2}R³³ᵣ₂) unit.

In one embodiment, p2 is 0, and q2 is each independently an integer of 1 to 3, preferably an integer of 2 to 3, still more preferably 3 for each (CR³¹ₚ₂R³²_{q2}R³³ᵣ₂) unit.

R^{e1} is each independently at each occurrence -Z³-SiR³⁴ₙ₂R³⁵₃₋ₙ₂. Such -Z³-SiR³⁴ₙ₂R³⁵₃₋ₙ₂ has the same definition as described in the above R^{32'}.

R^{f1} is each independently at each occurrence a hydrogen atom, a hydroxyl group, or a monovalent organic group. Such a monovalent organic group is a monovalent organic group excluding the above hydrolyzable group.

In R^{f1}, the monovalent organic group is preferably a C₁₋₂₀ alkyl group or -(CₛH₂ₛ)ₜ₁-(O-CₛH₂ₛ)ₜ₂ (wherein s is an integer of 1 to 6, preferably an integer of 2 to 4, t1 is 1 or 0, preferably 0, and t2 is an integer of 1 to 20, preferably an integer of 2 to 10, more preferably an integer of 2 to 6), more preferably a C₁₋₂₀ alkyl group, more preferably a C₁₋₆ alkyl group, particularly preferably a methyl group.

In one embodiment, R^{f1} is a hydroxyl group.

In another embodiment, the monovalent organic group as R^{f1} is preferably a C₁₋₂₀ alkyl group, more preferably a C₁₋₆ alkyl group.

k2 is each independently at each occurrence an integer of 0 to 3, l2 is each independently at each occurrence an integer of 0 to 3, and m2 is each independently at each occurrence 0 to 3. The sum of k2, l2, and m2 is 3 in the (CR^{d1}ₖ₂R^{e1}ₗ₂R^{f1}ₘ₂) unit.

In the formulae (1) and (2), when R^{Si} is a group represented by the formula (S4), preferably, at least two Si atoms to which a hydroxyl group or a hydrolyzable group is bonded are present in the ends of the formulae (1) and (2).

In one embodiment, when R^{Si} is a group represented by the formula (S4), two or more, for example, 2 to 27, preferably 2 to 9, more preferably 2 to 6, further preferably 2 to 3, particularly preferably 3 (SiR³⁴ₙ₂R³⁵₃₋ₙ₂) units in which n2 is 1 to 3, preferably 2 or 3, more preferably 3 are present in each end of the formula (1) and the formula (2).

In a preferred embodiment, when R^{32'} is present in the formula (S4), n2 is an integer of 1 to 3, preferably 2 or 3, more preferably 3 in at least one, preferably all of R^{32'} groups.

In a preferred embodiment, when R³² is present in the formula (S4), n2 is an integer of 1 to 3, preferably 2 or 3, more preferably 3 in at least one, preferably all of R³² groups.

In a preferred embodiment, when R^{e1} is present in the formula (S4), n2 is an integer of 1 to 3, preferably 2 or 3, more preferably 3 in at least one, preferably all of R^{a1} groups.

In a preferred embodiment, in the formula (S4), k2 is 0, l2 is 2 or 3, preferably 3, and n2 is 2 or 3, preferably 3.

R^{g1} and R^{h1} are each independently at each occurrence - Z⁴-SiR¹¹ₙ₁R¹²₃₋ₙ₁, -Z⁴-SiR^{a1}ₖ₁R^{b1}ₗ₁R^{c1}ₘ₁, or -Z⁴-CR^{d1}ₖ₂R^{e1}ₗ₂R^{f1}ₘ₂. Here, R¹¹, R¹², R^{a1}, R^{b2}, R^{c1}, R^{d1}, R^{e1}, R^{f1}, n1, k1, l1, m1, k2, l2, and m2 have the same definition as above.

R^{g1} and R^{h1} are each independently at each occurrence - Z⁴⁻SiR¹¹ₙ₁R¹²₃₋ₙ₁.

Z⁴ is each independently at each occurrence a single bond, an oxygen atom or a divalent organic group. The structure denoted as Z⁴ hereinafter is bonded to (SiR¹¹ₙ₁R¹²₃₋ₙ₁) on the right side.

In one embodiment, Z⁴ is an oxygen atom.

In one embodiment, Z⁴ is a divalent organic group.

Z⁴ is preferably a C₁₋₆ alkylene group, -(CH₂)_{z5"}-O-(CH₂)_{z6"}- (wherein z5" is an integer of 0 to 6; for example, an integer of 1 to 6, and z6" is an integer of 0 to 6; for example, an integer of 1 to 6), or - (CH₂)_{z7"}-phenylene-(CH₂)_{z8"}- (wherein z7" is an integer of 0 to 6; for example, an integer of 1 to 6, and z8" is an integer of 0 to 6; for example, an integer of 1 to 6) . Such a C₁₋₆ alkylene group may be linear or branched, and is preferably linear. These groups may be substituted with, for example, one or more substituents selected from a fluorine atom, a C₁₋₆ alkyl group, a C₂₋₆ alkenyl group, and a C₂₋₆ alkynyl group, but are preferably unsubstituted.

In a preferred embodiment, Z⁴ is a C₁₋₆ alkylene group or - (CH₂)_{z7"}-phenylene- (CH₂)_{z8"}-, preferably -phenylene-(CH₂)_{z8"}-. When Z³ is such a group, light resistance, in particular ultraviolet resistance, can be further enhanced.

In another preferred embodiment, Z⁴ is a C₁₋₃ alkylene group. In one embodiment, Z⁴ may be -CH₂CH₂CH₂-. In another embodiment, Z⁴ may be -CH₂CH₂-.

In one embodiment, R^{Si} is a group represented by the formula (S2), (S3), (S4), or (S5). These compounds are capable of forming a surface-treating layer having high surface lubricity.

In one embodiment, R^{Si} is a group represented by the formula (S1), (S3), (S4), or (S5). These compounds have a plurality of hydrolyzable groups at one end, and are therefore capable of forming a surface-treating layer which firmly adheres to a substrate and has high abrasion durability.

In one embodiment, R^{Si} is a group represented by the formula (S1), (S3) or (S4). These compounds have a plurality of hydrolyzable groups at one end, and are therefore capable of forming a surface-treating layer which firmly adheres to a substrate and has high abrasion durability.

In one embodiment, R^{Si} is a group represented by the formula (S3) or (S4). These compounds can have a plurality of hydrolyzable groups branched from one Si atom or C atom at one end, and are therefore capable of forming a surface-treating layer having higher abrasion durability.

In one embodiment, R^{Si} is a group represented by the formula (S1).

In one embodiment, R^{Si} is a group represented by the formula (S2).

In one embodiment, R^{Si} is a group represented by the formula (S3).

In one embodiment, R^{Si} is a group represented by the formula (S4).

In one embodiment, R^{Si} is a group represented by the formula (S5).

In the formulae (1) and (2), X^{A} is interpreted as a linker connecting fluoropolyether moieties (R^{F1} and R^{F2}), which mainly provide water-repellency, surface lubricity and the like, to a moiety (R^{Si}) providing a binding ability to a substrate. Accordingly, X^{A} may be a single bond or any group as long as the compound represented by the formula (I) or (2) can stably exist.

In the formula (1), α is an integer of 1 to 9, and β is an integer of 1 to 9. These α and β may vary depending on the valence of X^{A}. The sum of α and β is the same as the valence of X^{A}. For example, when X^{A} is a decavalent organic group, the sum of α and β is 10; for example, a case where α is 9 and β is 1, and α is 5 and β is 5, or α is 1 and β is 9, can be considered. When X^{A} is a divalent organic group, α and β each are 1.

In the formula (2), γ is an integer of 1 to 9. γ may vary according to the valence of X^{A}. That is, γ is a value obtained by subtracting 1 from the valence of X^{A}.

X^{A} is each independently a single bond or a di- to decavalent organic group.

In one embodiment, X^{A} does not contain a siloxane bond (-Si-O-Si-).

The di- to decavalent organic group in X^{A} is preferably a di- to octavalent organic group. In one embodiment, the di- to decavalent organic group is preferably a di- to tetravalent organic group, and more preferably a divalent organic group. In another embodiment, the di- to decavalent organic group is preferably a tri- to octavalent organic group, and more preferably a tri- to hexavalent organic group.

In one embodiment, X^{A} is a single bond or a divalent organic group, α is 1, and β is 1.

In one embodiment, X^{A} is a single bond or a divalent organic group, γ is 1.

In one embodiment, X^{A} is a tri- to hexavalent organic group, α is 1, and β is 2 to 5.

In one embodiment, X^{A} is a tri- to hexavalent organic group, and γ is 2 to 5.

In one embodiment, X^{A} is a trivalent organic group, α is 1, and β is 2.

In one embodiment, X^{A} is a trivalent organic group, and γ is 2.

When X^{A} is a single bond or a divalent organic group, the formulae (1) and (2) are represented by the following formulae (1') and (2').

R^{F1}-X^{A}-R^{Si} (1')

R^{Si}-X^{A}-R^{F2}-X^{A}-R^{Si} (2')

In one embodiment, X^{A} is a single bond.

In another embodiment, X^{A} is a divalent organic group.

In one embodiment, examples of X^{A} include a single bond or a divalent organic group represented by the following formula:

-(R⁵¹)ₚ₅-(X⁵¹)_{q5}-

wherein
R⁵¹ represents a single bond, -(CH₂)ₛ₅- or o-, m- or a p-phenylene group, and is preferably -(CH₂)ₛ₅-;
s5 is an integer of 1 to 20, preferably 1 to 6, more preferably 1 to 3, and still more preferably 1 or 2;
X⁵¹ represents -(X⁵²)₁₅-;
X⁵² each independently at each occurrence represents a group selected from the group consisting of -O-, -S-, o-, m- or a p-phenylene group, -C(O)O-, -Si(R⁵³)₂-, -(Si(R⁵³)₂O)ₘ₅-Si(R⁵³)₂-, -CONR⁵⁴-, -O-CONR⁵⁴-, -NR⁵⁴- and -(CH₂)ₙ₅-;
R⁵³ each independently at each occurrence represents a phenyl group, a C₁₋₆ alkyl group, or a C₁₋₆ alkoxy group, is preferably a phenyl group or a C₁₋₆ alkyl group, and is more preferably a methyl group;
R⁵⁴ each independently at each occurrence represents a hydrogen atom, a phenyl group, or a C₁₋₆ alkyl group (preferably a methyl group);
m5 is each independently at each occurrence an integer of 1 to 100 and preferably an integer of 1 to 20;
n5 is each independently at each occurrence an integer of 1 to 20, preferably an integer of 1 to 6, and more preferably an integer of 1 to 3;
15 is an integer of 1 to 10, preferably an integer of 1 to 5, and more preferably an integer of 1 to 3;
p5 is 0 or 1; and
q5 is 0 or 1,
where at least one of p5 and q5 is 1 and the occurrence order of the respective repeating units enclosed in parentheses provided with p5 or q5 is not limited.

Here, X^{A} (typically a hydrogen atom of X^{A}) may be substituted with one or more substituents selected from a fluorine atom, a C₁₋₃ alkyl group and a C₁₋₃ fluoroalkyl group. In a preferred embodiment, X^{A} is not substituted with any of these groups.

In a preferred embodiment, X^{A} is each independently - (R⁵¹)ₚ₅-(X⁵¹)_{q5}-R⁵²-. R⁵² represents a single bond, - (CH₂)t₅- or o-, m- or a p-phenylene group, and is preferably -(CH₂)ₜ₅-. t5 is an integer of 1 to 20, preferably an integer of 2 to 6, and more preferably an integer of 2 to 3. Here, R⁵² (typically a hydrogen atom of R⁵²) may be substituted with one or more substituents selected from a fluorine atom, a C₁₋₃ alkyl group and a C₁₋₃ fluoroalkyl group. In a preferred embodiment, R⁵⁶ is not substituted with these groups.

Preferably, X^{A} may each independently be
a single bond,
a C₁₋₂₀ alkylene group,

   -R⁵¹-X⁵³-R⁵²-,

   or

   -X⁵⁴-R⁵-
wherein R⁵¹ and R⁵² have the same definition as above; and
   X⁵³ represents

   -O-,

   -S-,

   -C(O)O-,

   -CONR⁵⁴-,

   -O-CONR⁵⁴-,

   -Si(R⁵³)₂-,

   -(Si(R⁵³)₂O)ₘ₅-Si(R⁵³)₂-,

   -O-(CH₂)ᵤ₅-(Si(R⁵³)₂O)ₘ₅-Si(R⁵³)₂-,

   -O-(CH₂)ᵤ₅-Si(R⁵³)₂-O-Si(R⁵³)₂-CH₂CH₂-Si(R⁵³)₂-O-Si(R⁵³)₂-,

   -O-(CH₂)ᵤ₅-Si(OCH₃)₂OSi(OCH₃)₂-,

   -CONR⁵⁴-(CH₂)ᵤ₅-(Si(R⁵³)₂O)ₘ₅-Si(R⁵³)₂-,

   -CONR⁵⁴-(CH₂)ᵤ₅-N(R⁵⁴)-,

   or

   -CONR⁵⁴-(o-, m- or p-phenylene) -Si(R⁵³)₂-,
wherein R⁵³, R⁵⁴, and m5 have the same definition as above, and
   u5 is an integer of 1 to 20, preferably an integer of 2 to 6, and more preferably an integer of 2 to 3;
   X⁵⁴ represents

   -S-,

   -C(O)O-,

   -CONR⁵⁴-,

   -O-CONR⁵⁴-,

   -CONR⁵⁴-(CH₂)ᵤ₅-(Si (R⁵⁴)₂O)ₘ₅-Si(R⁵⁴)₂-,

   -CONR⁵⁴-(CH₂)ᵤ₅-N(R⁵⁴)-,

   or

   -CONR⁵⁴-(o-, m- or p-phenylene) -Si (R⁵⁴)₂-,
wherein each symbol has the same definition as above.

More preferably, X^{A} is each independently
a single bond,
a C₁₋₂₀ alkylene group,

   - (CH₂)ₛ₅-X⁵³-,

   -(CH₂)ₛ₅-X⁵³-(CH₂)ₜ₅-,

   -X⁵⁴-,

   or

   -X⁵⁴-(CH₂)t₅-,
wherein X⁵³, X⁵⁴, s5, and t5 have the same definition as above.

More preferably, X^{A} may be each independently
a single bond,
a C₁₋₂₀ alkylene group,
-(CH₂)ₛ₅-X⁵³-(CH₂)t₅-,

   or

   -X⁵⁴-(CH₂)t₅-,
wherein each symbol has the same definition as above.

In a preferred embodiment, X^{A} may each independently be
a single bond,
a C₁₋₂₀ alkylene group,

   -(CH₂)ₛ₅-X⁵³-,

   or

   -(CH₂)ₛ₅-X⁵³-(CH₂)ₜ₅-,
wherein
   X⁵³ is -O-, -CONR⁵⁴-, or -O-CONR⁵⁴-;
   R⁵⁴ each independently at each occurrence represents a hydrogen atom, a phenyl group, or a C₁₋₆ alkyl group;
   s5 is an integer of 1 to 20; and
   t5 is an integer of 1 to 20.

In a preferred embodiment, X^{A} may each independently be

-(CH₂)ₛ₅-O-(CH₂)ₜ₅-

or

-CONR⁵⁴-(CH₂)t₅-,

wherein
R⁵⁴ each independently at each occurrence represents a hydrogen atom, a phenyl group, or a C₁₋₆ alkyl group;
s5 is an integer of 1 to 20; and
t5 is an integer of 1 to 20.

In one embodiment, X^{A} may each independently be
a single bond,
a C₁₋₂₀ alkylene group,

   - (CH₂)ₛ₅-O-(CH₂)t₅-,

   - (CH₂)ₛ₅-(Si(R⁵³)₂O)ₘ₅-Si(R⁵³)₂-(CH₂)t₅-,

   - (CH₂)ₛ₅-O-(CH₂)ᵤ₅-(Si(R⁵³)₂O)ₘ₅-Si(R⁵³)₂-(CH₂)ₜ₅-,

   or

   - (CH₂)ₛ₅-O-(CH₂)ₜ₅-Si(R⁵³)₂-(CH₂)ᵤ₅-Si(R⁵³)₂-(CᵥH₂ᵥ)-
wherein R⁵³, m5, s5, t5 and u5 have the same definition as above; v5 is an integer of 1 to 20, preferably an integer of 2 to 6, more preferably an integer of 2 to 3.

In the formula, -(CᵥH₂ᵥ)- may be linear or branched and may be, for example, -CH₂CH₂-, -CH₂CH₂CH₂-, -CH(CH₃)-, or - CH(CH₃)CH₂-.

X^{A} may be each independently substituted with one or more substituents selected from a fluorine atom, a C₁₋₃ alkyl group and a C₁₋₃ fluoroalkyl group (preferably a C₁₋₃ perfluoroalkyl group). In one embodiment, X^{A} is unsubstituted.

X^{A} is bonded to R^{F1} or R^{F2} on the left side, and bonded to R^{Si} on the right side.

In one embodiment, X^{A} may each independently be a group other than an -O-C₁₋₆ alkylene group.

In another embodiment, examples of the X^{A} group include the following groups: 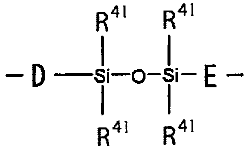 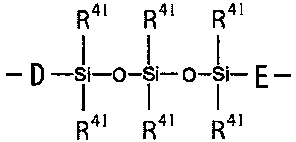 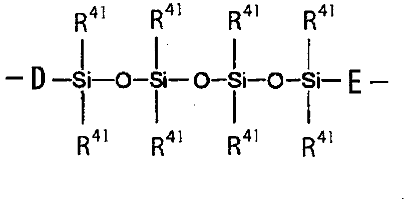 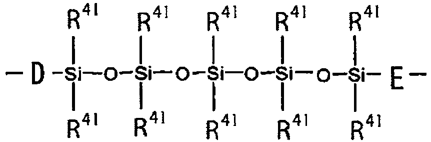 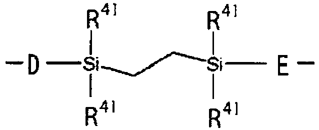 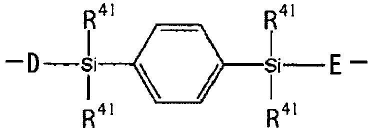 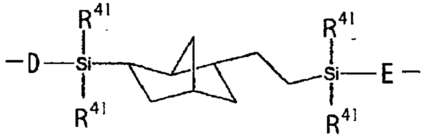 wherein R⁴¹ is each independently a hydrogen atom, a phenyl group, an alkyl group having 1 to 6 carbon atoms or a C₁₋₆ alkoxy group, and preferably a methyl group;
D is a group selected from

   -CH₂O(CH₂)₂-,

   -CH₂O(CH₂)₃-,

   -CF₂O(CH₂)₃-,

   -(CH₂)₂-,

   -(CH₂)₃-,

   -(CH₂)₄-,

   -CONH- (CH₂)₃-,

   -CON(CH₃)-(CH₂)₃-,

   and

   -CON(Ph)-(CH₂)₃-

   (wherein Ph means phenyl), and 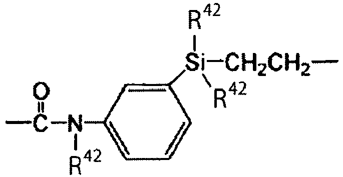 wherein R⁴² each independently represents a hydrogen atom, a C₁₋₆ alkyl group, or a C₁₋₆ alkoxy group, preferably a methyl group or a methoxy group, and more preferably a methyl group;
E is -(CH₂)ₙ- (n is an integer of 2 to 6); and
D binds to R^{F1} or R^{F2} of the molecular backbone and E binds to R^{Si}.

Specific examples of X^{A} include
a single bond,

   -CH₂OCH₂-,

   -CH₂O(CH₂)₂-,

   -CH₂O(CH₂)₃-,

   -CH₂O(CH₂)₄-,

   -CH₂O(CH₂)₅-,

   -CH₂O(CH₂)₆-,

   -CH₂O(CH₂)₃Si(CH₃)₂OSi(CH₃)₂(CH₂)₂-,

   -CH₂O(CH₂)₃Si(CH₃)₂OSi(CH₃)₂OSi(CH₃)₂(CH₂)₂-,

   -CH₂O(CH₂)₃Si(CH₃)₂O(Si(CH₃)₂O)₂Si(CH₃)₂(CH₂)₂-,

   -CH₂O(CH₂)₃Si(CH₃)₂O(Si(CH₃)₂O)₃Si(CH₃)₂(CH₂)₂-,

   -CH₂O(CH₂)₃Si(CH₃)₂O(Si(CH₃)₂O)₁₀Si(CH₃)₂(CH₂)₂-,

   -CH₂O(CH₂)₃Si(CH₃)₂O(Si (CH₃)₂O)₂₀Si(CH₃)₂(CH₂)₂-,

   -CH₂OCF₂CHFOCF₂-,

   -CH₂OCF₂CHFOCF₂CF₂-,

   -CH₂OCF₂CHFOCF₂CF₂CF₂-,

   -CH₂OCH₂CF₂CF₂OCF₂-,

   -CH₂OCH₂CF₂CF₂OCF₂CF₂-

   -CH₂OCH₂CF₂CF₂OCF₂CF₂CF₂-,

   -CH₂OCH₂CF₂CF₂OCF(CF₃)CF₂OCF₂-,

   -CH₂OCH₂CF₂CF₂OCF(CF₃)CF₂OCF₂CF₂-,

   -CH₂OCH₂CF₂CF₂OCF(CF₃)CF₂OCF₂CF₂CF₂-,

   -CH₂OCH₂CHFCF₂OCF₂-,

   -CH₂OCH₂CHFCF₂OCF₂CF₂-,

   -CH₂OCH₂CHFCF₂OCF₂CF₂CF₂-,

   -CH₂OCH₂CHFCF₂OCF(CF₃)CF₂OCF₂-,

   -CH₂OCH₂CHFCF₂OCF(CF₃)CF₂OCF₂CF₂-,

   -CH₂OCH₂CHFCF₂OCF(CF₃)CF₂OCF₂CF₂CF₂-,

   -CH₂OCF₂CHFOCF₂CF₂CF₂-C(O)NH-CH₂-,

   CH₂OCH₂(CH₂)₇CH₂Si(OCH₃)₂OSi(OCH₃)₂(CH₂)₂Si(OCH₃)₂₀Si(OCH₃)₂(CH₂ )₂-,

   -CH₂OCH₂CH₂CH₂Si(OCH₃)₂OSi(OCH₃)₂(CH₂)₃-,

   -CH₂OCH₂CH₂CH₂Si(OCH₂CH₃)₂OSi(OCH₂CH₃)₂(CH₂)₃-,

   -CH₂OCH₂CH₂CH₂Si(OCH₃)₂OSi(OCH₃)₂(CH₂)₂-,

   -CH₂OCH₂CH₂CH₂Si(OCH₂CH₃)₂OSi(OCH₂CH₃)₂(CH₂)₂-,

   -(CH₂)₂-Si(CH₃)₂-(CH₂)₂-,

   -CH₂-,

   -(CH₂)₂-,

   -(CH₂)₃-,

   -(CH₂)₄-,

   -(CH₂)₅-,

   -(CH₂)₆-,

   -CO-,

   -CONH-,

   -CONH-CH₂-,

   -CONH-(CH₂)₂-,

   -CONH-(CH₂)₃-,

   -CONH-(CH₂)₄-,

   -CONH-(CH₂)₅-,

   -CONH-(CH₂)₆-,

   -CON(CH₃)-CH₂-,

   -CON(CH₃)-(CH₂)₂-,

   -CON(CH₃)-(CH₂)₃-,

   -CON(CH₃)-(CH₂)₄-,

   -CON(CH₃)-(CH₂)₅-,

   -CON(CH₃)-(CH₂)₆-,

   -CON(Ph)-CH₂-

   (wherein Ph means phenyl),

   -CON(Ph)-(CH₂)₂-

   (wherein Ph means phenyl),

   -CON(Ph)-(CH₂)₃-

   (wherein Ph means phenyl),

   -CON(Ph)-(CH₂)₄-

   (wherein Ph means phenyl),

   -CON(Ph)-(CH₂)₅-

   (wherein Ph means phenyl),

   -CON(Ph)-(CH₂)₆-

   (wherein Ph means phenyl),

   -CONH-(CH₂)₂NH(CH₂)₃-,

   -CONH-(CH₂)₆NH(CH₂)₃-,

   -CH₂O-CONH-(CH₂)₃-,

   -CH₂O-CONH-(CH₂)₆-,

   -S-(CH₂)₃-,

   - (CH₂)₂S(CH₂)₃-,

   -CONH-(CH₂)₃Si(CH₃)₂OSi(CH₃)₂(CH₂)₂-,

   -CONH-(CH₂)₃Si(CH₃)₂OSi(CH₃)₂OSi(CH₃)₂(CH₂)₂-,

   -CONH-(CH₂)₃Si(CH₃)₂O(Si(CH₃)₂O)₂Si(CH₃)₂(CH₂)₂-,

   -CONH-(CH₂)₃Si(CH₃)₂O(Si(CH₃)₂O)₃Si(CH₃)₂(CH₂)₂-,

   -CONH-(CH₂)₃Si(CH₃)₂O(Si(CH₃)₂O)₁₀Si(CH₃)₂(CH₂)₂-,

   -CONH-(CH₂)₃Si(CH₃)₂O(Si(CH₃)₂O)₂₀Si(CH₃)₂(CH₂)₂-,

   -C(O)O-(CH₂)₃-,

   -C(O)O-(CH₂)₆-,

   -CH₂-O-(CH₂)₃-Si(CH₃)₂-(CH₂)₂-Si(CH₃)₂-(CH₂)₂-,

   -CH₂-O-(CH₂)₃-Si(CH₃)₂-(CH₂)₂-Si(CH₃)₂-CH(CH₃)-,

   -CH₂-O-(CH₂)₃-Si(CH₃)₂-(CH₂)₂-Si(CH₃)₂-(CH₂)₃-,

   -CH₂-O-(CH₂)₃-Si(CH₃)₂-(CH₂)₂-Si(CH₃)₂-CH(CH₃)-CH₂-,

   -OCH₂-,

   -O(CH₂)₃-,

   -OCFHCF₂-,

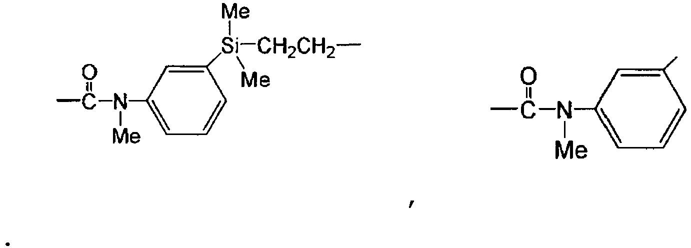

In still another embodiment, X^{A} is each independently a group represented by formula: -(R¹⁶)ₓ₁-(CFR¹⁷)_{y1}-(CH₂)_{z1}-. In the formula, x1, y1 and z1 are each independently an integer of 0 to 10, and the sum of x1, y1 and z1 is 1 or more, the occurrence order of the respective repeating units enclosed in parentheses is not limited in the formula.

In the formula, R¹⁶ is each independently at each occurrence an oxygen atom, phenylene, carbazolylene, -NR¹⁸-(in the formula, R¹⁸ represents a hydrogen atom or an organic group), or a divalent organic group. Preferably, R¹⁸ is an oxygen atom or a divalent polar group.

Examples of the "divalent polar group" include, but are not limited to, -C(O)-, -C(=NR¹⁹)- and -C(O)NR¹⁹- (wherein R¹⁹ represents a hydrogen atom or a lower alkyl group). The "lower alkyl group" is, for example, an alkyl group having 1 to 6 carbon atoms, such as methyl, ethyl, and n-propyl that is optionally substituted with one or more fluorine atoms.

In the formulae, R¹⁷ is each independently at each occurrence a hydrogen atom, a fluorine atom, or a lower fluoroalkyl group, and is preferably a fluorine atom. The "lower fluoroalkyl group" is, for example, a fluoroalkyl group having 1 to 6 carbon atoms and preferably 1 to 3 carbon atoms, preferably a perfluoroalkyl group having 1 to 3 carbon atoms, more preferably a trifluoromethyl group or pentafluoroethyl group, and still more preferably a trifluoromethyl group.

In still another embodiment, examples of X^{A} include the following group: 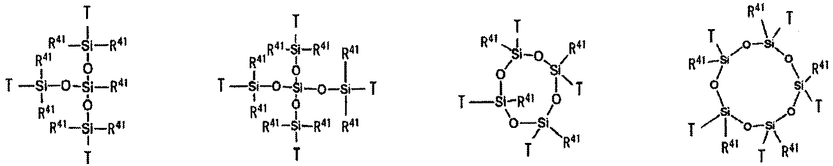 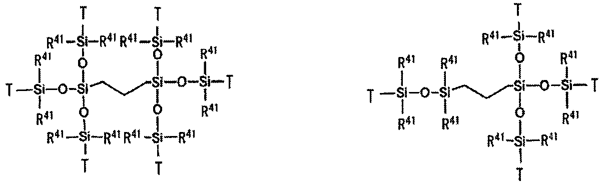 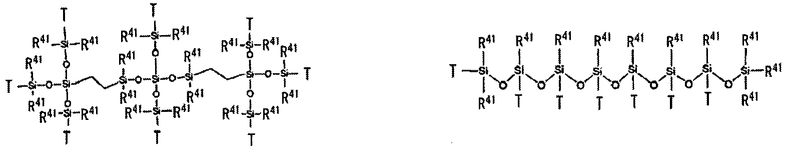 wherein
R⁴¹ is each independently a hydrogen atom, a phenyl group, an alkyl group having 1 to 6 carbon atoms, or a C₁₋₆ alkoxy group, and is preferably a methyl group;
some of the groups of T in each X^{A} group are the following groups bonded to R^{F1} or R^{F2} of the molecular backbone:

   -CH₂O(CH₂)₂-,

   -CH₂O(CH₂)₃-,

   -CF₂O(CH₂)₃-,

   -(CH₂)₂⁻,

   -(CH₂)₃-,

   -(CH₂)₄-,

   -CONH-(CH₂)₃-,

   -CON(CH₃)-(CH₂)₃-,

   -CON(Ph)-(CH₂)₃-

   (wherein Ph means phenyl), or 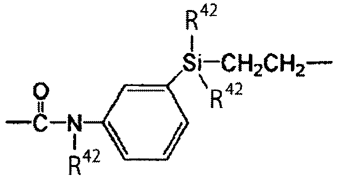
wherein R⁴² each independently represents a hydrogen atom, a C₁₋₆ alkyl group, or a C₁₋₆ alkoxy group, preferably a methyl group or a methoxy group, and more preferably a methyl group; and
some other groups of T are bonded to R^{Si} of the molecular backbone, and the remaining groups of T, if present, are each independently a methyl group, a phenyl group, a C₁₋₆ alkoxy group, or a radical scavenging group or a UV absorbing group.

The radical scavenging group is not limited as long as it can scavenge a radical generated by light irradiation, and examples thereof include residues of benzophenones, benzotriazoles, benzoates, phenyl salicylates, crotonic acids, malonates, organoacrylates, hindered amines, hindered phenols, and triazines.

The UV absorbing group is not limited as long as it can absorb ultraviolet rays, and examples thereof include residues of benzotriazoles, hydroxybenzophenones, esters of substituted and unsubstituted benzoic acid or salicylic acid compounds, acrylates or alkoxy cinnamates, oxamides, oxanilides, benzoxazinones, and benzoxazoles.

In a preferred embodiment, examples of the preferred radical scavenging group or UV absorbing group include:

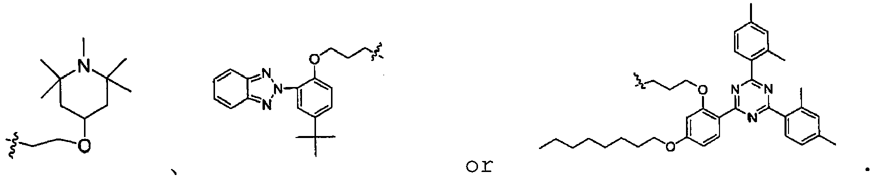

In this embodiment, X^{A} may each independently be a tri-to decavalent organic group.

In still another embodiment, examples of X^{A} include the following group: 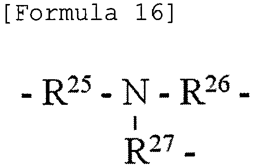 wherein R²⁵, R²⁶, and R²⁷ are each independently a di- to hexavalent organic group; and
R²⁵ binds to at least one R^{F1}, and R²⁶ and R²⁷ each bind to at least one R^{Si}.

In one embodiment, R²⁵ is a single bond, a C₁₋₂₀ alkylene group, a C₃₋₂₀ cycloalkylene group, a C₅₋₂₀ arylene group, - R⁵⁷-X⁵⁸-R⁵⁹-, -X⁵⁸-R⁵⁹-, or -R⁵⁷-X⁵⁸-. R⁵⁷ and R⁵⁹ are each independently a single bond, a C₁₋₂₀ alkylene group, a C₃₋₂₀ cycloalkylene group, or a C₅₋₂₀ arylene group. X⁵⁸ is -O-, - S-, -CO-, -O-CO-, or -COO-.

In one embodiment, R²⁶ and R²⁷ are each independently a hydrocarbon, or a group having at least one atom selected from N, O and S at the end or in the main chain of a hydrocarbon, and preferred examples thereof include C₁₋₆ alkyl groups, -R³⁶-R³⁷-R³⁶ and -R³⁶-CHR³⁸₂-. Here, R³⁶ is each independently a single bond or an alkyl group having 1 to 6 carbon atoms, preferably an alkyl group having 1 to 6 carbon atoms. R³⁷ is N, O or S, preferably N or O. R³⁸ is -R⁴⁵-R⁴⁶-R⁴⁵-, -R⁴⁶-R⁴⁵- or -R⁴⁵-R⁴⁶-. where R⁴⁵ is each independently an alkyl group having 1 to 6 carbon atoms. R⁴⁶ is N, O or S, preferably O.

In this embodiment, X^{A} may each independently be a tri-to decavalent organic group.

In one embodiment, the fluoropolyether group-containing silane compound of formula (1) or (2) does not contain a siloxane bonds (-Si-O-Si-).

The fluoropolyether group-containing silane compound represented by the formula (1) or the formula (2) is not limited, but may have an average molecular weight of 5 × 10² to 1 × 10⁵. In particular, the average molecular weight is preferably 2,000 to 32,000, more preferably 2,500 to 12,000, from the viewpoint of abrasion durability. The "average molecular weight" refers to a number average molecular weight, and the "average molecular weight" is a value obtained by ¹⁹F-NMR measurement.

In one embodiment, the fluoropolyether group-containing silane compound in the surface-treating agent of the present disclosure is a compound represented by the formula (1).

In another embodiment, the fluoropolyether group-containing silane compound in the surface-treating agent of the present disclosure is a compound represented by the formula (2).

In another embodiment, the fluoropolyether group-containing silane compound in the surface-treating agent of the present disclosure is any of a compound represented by the formula (1) and a compound represented by the formula (2).

In the surface-treating agent of the present disclosure, the content of the compound represented by the formula (2) is preferably 0.1 mol% or more and 35 mol% or less based on the total of the compound represented by the formula (1) and the compound represented by the formula (2). The lower limit of the content of the compound represented by the formula (2) may be preferably 0.1 mol%, more preferably 0.2 mol%, still more preferably 0.5 mol%, further more preferably 1 mol%, particularly preferably 2 mol%, especially 5 mol%, based on the total of the compound represented by the formula (1) and the compound represented by the formula (2). The upper limit of the content of the compound represented by the formula (2) can be preferably 35 mol%, more preferably 30 mol%, still more preferably 20 mol%, further more preferably 15 mol% or 10 mol%, based on the total of the compound represented by the formula (1) and the compound represented by the formula (2). The compound represented by the formula (2) is preferably 0.1 mol% or more and 30 mol% or less, more preferably 0.1 mol% or more and 20 mol% or less, still more preferably 0.2 mol% or more and 10 mol% or less, further more preferably 0.5 mol% or more and 10 mol% or less, and particularly preferably 1 mol% or more and 10 mol% or less, for example, 2 mol% or more and 10 mol% or less, or 5 mol% or more and 10 mol% or less, based on the total of the compound represented by the formula (1) and the compound represented by the formula (2). When the content of the compound represented by the formula (2) is within the above-mentioned range, abrasion durability can be further improved.

The compound represented by the formula (1) or (2) can be obtained by a method described in, for example, Patent Literature 1.

The content of the compound represented by the formula (1) or (2) may be preferably 0.1 to 50.0% by mass, more preferably 1.0 to 30.0% by mass, still more preferably 5.0 to 25.0% by mass, particularly preferably 10.0 to 20.0% by mass, based on the total amount of the surface-treating agent. When the content of the fluoropolyether group-containing silane compound falls within the above range, higher water- and oil-repellency can be obtained.

### (Amide compound)

The amide compound is a compound that contains an amide group and can improve the abrasion durability of the surface-treating layer formed from the surface-treating agent of the present disclosure.

In a preferred embodiment, the amide compound is an amide compound represented by the following formula (A):

NR⁶¹R⁶²-COR⁶³ (A)

wherein
R⁶¹ is a hydrogen atom or a C₁₋₁₀ alkyl group (preferably a C₁₋₆ alkyl group);
R⁶² is a C₁₋₁₀ alkyl group (preferably a C₁₋₆ alkyl group) ;
R⁶³ is a hydrogen atom, a C₁₋₁₀ alkyl group (preferably a C₁₋₆ alkyl group), NR⁶⁵₂, or -R⁶⁶ₓ-R⁶⁷_{y}-R⁶⁸;
or, R⁶² and R⁶³ are bonded to each other to form -R⁶²-R⁶³-, wherein -R⁶²-R⁶³- is a C₃₋₄ alkylene group or -C₂₋₃ alkylene-NR⁶⁵-;
R⁶⁵ is each independently a hydrogen atom or a C₁₋₁₀ alkyl group (preferably a C₁₋₆ alkyl group);
R⁶⁶ is each independently at each occurrence a C₁₋₆ alkylene group;
R⁶⁷ is an oxygen atom or CO;
R⁶⁸ is a C₁₋₁₀ alkyl group (preferably a C₁₋₆ alkyl group) ;
x is an integer of 1 to 6; and
y is an integer of 1 to 6,
with the proviso that each occurrence order of R⁶⁶ and R⁶⁷ in -R⁶⁶ₓ-R⁶⁷_{y}-R⁶⁸ is not limited.

In the formula (A), the alkyl group may be linear or branched. The alkyl group is preferably linear.

In the formula (A), the alkylene group may be linear or branched. The alkylene group is preferably linear.

R⁶¹ is a hydrogen atom or a C₁₋₁₀ alkyl group.

In one embodiment, R⁶¹ is a hydrogen atom.

In another embodiment, R⁶¹ is a C₁₋₁₀ alkyl group.

The C₁₋₁₀ alkyl group is preferably a C₁₋₆ alkyl group, more preferably a C₁₋₃ alkyl group, and still more preferably a C₁₋₂ alkyl group.

R⁶² is a C₁₋₁₀ alkyl group, and is preferably a C₁₋₆ alkyl group, more preferably a C₁₋₃ alkyl group, and still more preferably a C₁₋₂ alkyl group.

In a preferred embodiment, R⁶¹ and R⁶² are a C₁₋₂ alkyl group, preferably a methyl group or an ethyl group, and more preferably a methyl group.

R⁶³ is a hydrogen atom, a C₁₋₁₀ alkyl group, NR⁶⁵₂, or - R⁶⁶ₓ-R⁶⁷_{y}-R⁶⁸; or R⁶² and R⁶³ are bonded to each other to form -R⁶²-R⁶³-, where -R⁶²-R⁶³- is a C₃₋₄ alkylene group or -C₂₋₃ alkylene-NR⁶⁵-.

In one embodiment, R⁶³ is a hydrogen atom.

In one embodiment, R⁶³ is a C₁₋₁₀ alkyl group, and is preferably a C₁₋₆ alkyl group, more preferably a C₁₋₄ alkyl group, still more preferably a C₁₋₃ alkyl group, and particularly preferably a methyl group or an ethyl group.

In one embodiment, R⁶³ is NR⁶⁵₂.

R⁶⁵ is each independently a hydrogen atom or a C₁₋₁₀ alkyl group, preferably a C₁₋₁₀ alkyl group. The C₁₋₁₀ alkyl group is preferably a C₁₋₆ alkyl group, more preferably a C₁₋₄ alkyl group, still more preferably a C₁₋₃ alkyl group, and particularly preferably a methyl group.

In -R⁶⁶ₓ-R⁶⁷_{y}-R⁶⁸, R⁶⁶ is each independently at each occurrence a C₁₋₆ alkylene group (preferably C₁₋₄ alkylene group, more preferably C₂₋₃ alkylene group); R⁶⁷ is an oxygen atom; R⁶⁸ is a C₁₋₆ alkyl group (preferably C₁₋₉ alkyl group) ; x is an integer of 1 to 6 (preferably an integer of 1 to 3); y is an integer of 1 to 6 (preferably an integer of 1 to 3); the occurrence order of R⁶⁶ and R⁶⁷ in -R⁶⁶ₓ-R⁶⁷_{y}-R⁶⁸ is not limited. Preferably, -R⁶⁶ₓ-R⁶⁷_{y}-R⁶⁸ is bonded to the carbon atom of the amide group by R⁶⁶.

In one embodiment, R⁶³ is -R⁶⁶ₓ-R⁶⁷_{y}-R⁶⁸, preferably -R⁶⁶-R⁶⁷-R⁶⁸. In one embodiment, R⁶³ is -R⁶⁶-O-R⁶⁸-. In another embodiment, R⁶³ is -R⁶⁶-CO-R⁶⁸-.

In another embodiment, R⁶² and R⁶³ are bonded to each other to form -R⁶²-R⁶³-, where -R⁶²-R⁶³- is a C₃₋₄ alkylene group or -C₂₋₃ alkylene-NR⁶⁵-. That is, R⁶² and R⁶³, together with the nitrogen atom and carbon atom to which they are bonded, form a 5- or 6-membered ring. In a preferred embodiment, such a 5- or 6-membered ring is a pyrrolidone ring or a tetrahydropyrimidinone ring that may be N-substituted.

In a preferred embodiment, R⁶¹ and R⁶² are a C₁₋₂ alkyl group, R⁶³ is -R⁶⁶-O-R⁶⁸, R⁶⁶ is a C₂₋₃ alkylene group, and R⁶⁸ is a C₁₋₄ alkyl group.

In another preferred embodiment, R⁶¹ is a C₁₋₂ alkyl group, and R⁶² and R⁶³ are bonded to each other to form -R⁶²-R⁶³-, where -R⁶²-R⁶³- is a C₃ alkylene group.

The boiling point of the above amide compound under atmospheric pressure is preferably 150 to 300°C, more preferably 180 to 260°C.

The content of the amide compound is 0.5 to 10.0% by mass based on the total amount of the surface-treating agent. The surface-treating agent of the present disclosure can form a surface-treating layer having high abrasion durability by containing the amide compound in the content described above.

In a preferred embodiment, the content of the amide compound is preferably 1.0 to 9.0% by mass based on the total amount of the surface-treating agent.

In a preferred embodiment, in the surface-treating agent of the present disclosure, the mass ratio of the fluoropolyether group-containing silane compound to the amide compound is preferably 1:100 to 50:1, more preferably 1:50 to 30:1, and still more preferably 1:30 to 20:1.

In one embodiment, in the surface-treating agent of the present disclosure, the mass ratio of the fluoropolyether group-containing silane compound to the amide compound is preferably 1:1 to 50:1, more preferably 2:1 to 40:1, still more preferably 2:1 to 10:1, and further preferably 2:1 to 5:1.

The surface-treating agent of the present disclosure imparts water- and oil-repellency to the surface-treating layer by containing the fluoropolyether group-containing silane compound, and imparts high abrasion durability to the surface-treating layer by containing the amide compound. Although the present invention is not bound by any theory, it is considered that this is because the fluoropolyether group-containing silane compound in the surface-treating agent suppresses condensation by the amide compound. Therefore, when the fluoropolyether group-containing silane compound has a plurality of Si atoms bonded to the hydrolyzable group, the effect can be more effectively obtained.

The surface-treating agent of the present disclosure can contain a (unreactive) fluoropolyether compound which can be understood as solvent or fluorine-containing oil, preferably a perfluoro(poly)ether compound (hereinafter, referred to collectively as "fluorine-containing oil"), a (unreactive) silicone compound which can be understood as a silicone oil (hereinafter, referred to as "silicone oil"), an alcohol, a compatibilizing agent, a catalyst, a surfactant, a polymerization inhibitor, a sensitizer and the like.

Examples of the solvent include aliphatic hydrocarbons such as hexane, cyclohexane, heptane, octane, nonane, decane, undecane, dodecane, and mineral spirits; aromatic hydrocarbons such as benzene, toluene, xylene, naphthalene, and solvent naphtha; esters such as methyl acetate, ethyl acetate, propyl acetate, n-butyl acetate, isopropyl acetate, isobutyl acetate, cellosolve acetate, propylene glycol methyl ether acetate, carbitol acetate, diethyl oxalate, ethyl pyruvate, ethyl 2-hydroxybutyrate, ethyl acetoacetate, amyl acetate, methyl lactate, ethyl lactate, methyl 3-methoxypropionate, ethyl 3-methoxypropionate, methyl 2-hydroxyisobutyrate, and ethyl 2-hydroxyisobutyrate; ketones such as acetone, methyl ethyl ketone, methyl isobutyl ketone, 2-hexanone, cyclohexanone, methyl amino ketone, and 2-heptanone; glycol ethers such as ethyl cellosolve, methyl cellosolve, methyl cellosolve acetate, ethyl cellosolve acetate, propylene glycol monomethyl ether, propylene glycol monoethyl ether, propylene glycol monobutyl ether, propylene glycol monomethyl ether acetate, propylene glycol monoethyl ether acetate, propylene glycol monobutyl ether acetate, dipropylene glycol dimethyl ether, and ethylene glycol monoalkyl ether; alcohols such as methanol, ethanol, iso-propanol, n-butanol, isobutanol, tert-butanol, sec-butanol, 3-pentanol, octyl alcohol, 3-methyl-3-methoxybutanol, and tert-amyl alcohol; glycols such as ethylene glycol and propylene glycol; cyclic ethers such as tetrahydrofuran, tetrahydropyran, and dioxane; amides such as N,N-dimethylformamide and N,N-dimethylacetamide; ether alcohols such as methyl cellosolve, cellosolve, isopropyl cellosolve, butyl cellosolve, and diethylene glycol monomethyl ether; diethylene glycol monoethyl ether acetate; and fluorine-containing solvents such as 1,1,2-trichloro-1,2,2-trifluoroethane, 1,2-dichloro-1,1,2,2-tetrafluoroethane, dimethyl sulfoxide, 1,1-dichloro-1,2,2,3,3-pentafluoropropane (HCFC 225), Zeorora H, HFE 7100, HFE 7200, HFE 7300, CF₃CH₂OH, CF₃CF₂CH₂OH, and (CF₃)₂CHOH. Alternatively, the solvent may be a mixed solvent of two or more of such solvents.

The fluorine-containing oil is not limited, and examples thereof include a compound (perfluoro(poly)ether compound) represented by the following general formula (3).

Rf⁵-(OC₄F₈)_{a'}-(OC₃F₆)_{b'}-(OC₂F₄)_{c'}-(OCF₂)_{d'}-Rf⁶ ... (3)

In the formula, Rf⁵ represents an alkyl group having 1 to 16 carbon atoms optionally substituted with one or more fluorine atoms (preferably, a C₁₋₁₆ perfluoroalkyl group), Rf⁶ represents an alkyl group having 1 to 16 carbon atoms optionally substituted with one or more fluorine atoms (preferably, a C₁₋₁₆ perfluoroalkyl group), a fluorine atom, or a hydrogen atom, and Rf⁵ and Rf⁶ are each independently, more preferably, a C₁₋₃ perfluoroalkyl group.

a', b', c', and d' represent the respective four numbers of repeating units in perfluoro(poly)ether constituting the main backbone of the polymer and are mutually independently an integer of 0 or more and 300 or less, and the sum of a', b', c', and d' is at least 1, preferably 1 to 300, more preferably 20 to 300. The occurrence order of the respective repeating units enclosed in parentheses provided with the subscript a', b', c', or d' is not limited in the formula. Among such repeating units, -(OC₄F₈)- may be any of-(OCF₂CF₂CF₂CF₂)-, -(OCF(CF₃)CF₂CF₂)-, -(OCF₂CF(CF₃)CF₂)-,-(OCF₂CF₂CF(CF₃))-, -(OC(CF₃)₂CF₂)-, -(OCF₂C(CF₃)₂)-,-(OCF(CF₃)CF(CF₃))-, -(OCF(C₂F₅)CF₂)-, and (OCF₂CF(C₂F₅))-, but it is preferably -(OCF₂CF₂CF₂CF₂)-. -(OC₃F₆)- may be any of -(OCF₂CF₂CF₂)-, -(OCF(CF₃)CF₂)-, and (OCF₂CF(CF₃))-, and it is preferably -(OCF₂CF₂CF₂)-. -(OC₂F₄)- may be any of -(OCF₂CF₂)-and (OCF(CF₃))-, but it is preferably -(OCF₂CF₂)-.

Examples of the perfluoro(poly)ether compound represented by the above general formula (3) include a compound represented by any of the following general formulae (3a) and (3b) (which may be used singly or as a mixture of two or more kinds thereof).

Rf⁵-(OCF₂CF₂CF₂)_{b"}-Rf⁶ ... (3a)

Rf⁵-(OCF₂CF₂CF₂CF₂)_{a"}-(OCF₂CF₂CF₂)_{b"}-(OCF₂CF₂)_{c"}-(OCF₂)_{d"}-Rf⁶ ... (3b)

In these formulae, Rf⁵ and Rf⁶ are as described above; in formula (3a), b" is an integer of 1 or more and 100 or less; and in formula (3b), a" and b" are each independently an integer of 0 or more and 30 or less, and c'' and d'' are each independently an integer of 1 or more and 300 or less. The occurrence order of the respective repeating units enclosed in parentheses provided with the subscript a", b", c", or d'' is not limited in the formula.

Alternatively, from another viewpoint, the fluorine-containing oil may be a compound represented by general formula Rf³-F, wherein Rf³ is a C₅₋₁₆ perfluoroalkyl group. The fluorine-containing oil may be a chlorotrifluoroethylene oligomer.

The above fluorine-containing oil may have an average molecular weight of 500 to 10,000. The molecular weight of the fluorine-containing oil can be measured using GPC.

The fluorine-containing oil may be contained in an amount of, for example, 0 to 50 mass%, preferably 0 to 30 mass%, and more preferably 0 to 5 mass% based on the surface-treating agent of the present disclosure. In one embodiment, the surface-treating agent of the present disclosure is substantially free from the fluorine-containing oil. Being substantially free from the fluorine-containing oil means that the fluorine-containing oil is not contained at all, or an extremely small amount of the fluorine-containing oil may be contained.

In one embodiment, the average molecular weight of the fluorine-containing oil may be greater than the average molecular weight of the fluoropolyether group-containing silane compound. With such average molecular weights, better abrasion durability and surface lubricity can be obtained, in the case of forming the surface-treating layer by the vacuum deposition method.

In one embodiment, the average molecular weight of the fluorine-containing oil may be smaller than the average molecular weight of the fluoropolyether group-containing silane compound. With such average molecular weights, it is possible to form a cured product having high abrasion durability and high surface lubricity while suppressing reduction in the transparency of a surface-treating layer obtained from the compound.

The fluorine-containing oil contributes to improving surface lubricity of the layer formed by the surface-treating agent of the present disclosure.

For example, a linear or cyclic silicone oil having 2,000 or less siloxane bonds can be used as the silicone oil. The linear silicone oil may be a so-called straight silicone oil or modified silicone oil. Examples of the straight silicone oil include dimethyl silicone oil, methyl phenyl silicone oil, and methyl hydrogen silicone oil. Examples of the modified silicone oil include those obtained by modifying a straight silicone oil with alkyl, aralkyl, polyether, higher fatty acid ester, fluoroalkyl, amino, epoxy, carboxyl, alcohol, or the like. Examples of the cyclic silicone oil include cyclic dimethylsiloxane oil.

In the surface-treating agent of the present disclosure, such a silicone oil may be contained in an amount of, for example, 0 to 300 parts by mass, and preferably 50 to 200 parts by mass, based on the total 100 parts by mass of the above fluoropolyether group-containing silane compound of the present disclosure (in the case of two or more kinds, the total thereof, and the same applies below).

The silicone oil contributes to improving the surface lubricity of the surface-treating layer.

Examples of the alcohols include alcohols having 1 to 6 carbon atoms optionally substituted with one or more fluorine atoms, such as methanol, ethanol, iso-propanol, tert-butanol, CF₃CH₂OH, CF₃CF₂CH₂OH, and (CF₃)₂CHOH. By adding these alcohols to the surface-treating agent, the stability of the surface-treating agent is improved, and the miscibility between the perfluoropolyether group-containing silane compound and the solvent is improved.

Examples of the compatibilizing agent include a fluorine-substituted alcohol such as 2,2,2-trifluoroethanol, 2,2,3,3,3-pentafluoro-1-propanol, or 2,2,3,3,4,4,5,5-octafluoro-1-pentanol, preferably a fluorine-substituted alcohol having a CF₂H end, and a fluorine-substituted aryl such as 1,3-bis(trifluoromethyl)benzene, preferably a fluorine-substituted benzene.

Examples of the above catalyst include an acid (such as acetic acid and trifluoroacetic acid), a base (such as ammonia, triethylamine, and diethylamine), and a transition metal (such as Ti, Ni, and Sn).

The catalyst promotes hydrolysis and dehydrative condensation of the fluoropolyether group-containing silane compound of the present disclosure, and promotes formation of a layer formed of the surface-treating agent of the present disclosure.

Examples of the other components include, in addition to those described above, tetraethoxysilane, methyltrimethoxysilane, 3-aminopropyltrimethoxysilane, 3-glycidoxypropyltrimethoxysilane, and methyltriacetoxysilane.

The surface-treating agent of the present disclosure can be formed into pellets by impregnating a porous material such as a porous ceramic material or a metal fiber such as a fiber obtained by, for example, solidifying steel wool in a cotton-like form therewith. Such pellets can be used in, for example, vacuum deposition.

The surface-treating agent of the present disclosure may contain, in addition to the above-described components, a trace amount of impurities such as Pt, Rh, Ru, 1,3-divinyltetramethyldisiloxane, triphenylphosphine, NaCl, KCl, and silane condensates.

Hereinafter, an article of the present disclosure will be described.

The article of the present disclosure comprises a substrate and a layer (surface-treating layer) on a surface of the substrate, the layer being formed of the surface-treating agent according to the present disclosure.

The substrate usable in the present disclosure may be composed of any suitable material such as glass, resin (which may be natural or synthetic resin such as a commonly used plastic material), metal, ceramics, semiconductors (such as silicon and germanium), fiber (such as woven fabric and nonwoven fabric), fur, leather, wood, pottery, stone, building materials, and sanitary articles.

For example, when the article to be produced is an optical member, the material constituting the surface of the substrate may be a material for an optical member, such as glass or a transparent plastic. When the article to be produced is an optical member, some layer (or film) such as a hard coat layer or an antireflection layer may be formed on the surface (the outermost layer) of the substrate. The antireflection layer may be any of a single-layer antireflection layer and a multi-layer antireflection layer. Examples of inorganic substances usable in the antireflection layer include SiO₂, SiO, ZrO₂, TiO₂, TiO, Ti₂O₃, Ti₂O₅, Al₂O₃, Ta₂O₅, Ta₃O₅, Nb₂O₅, HfO₂, Si₃N₄, CeO₂, MgO, Y₂O₃, SnO₂, MgF₂, and WO₃. One of these inorganic substances may be used singly, or two or more kinds thereof may be used in combination (for example, as a mixture). In the case of a multi-layer antireflection layer, it is preferable to use SiO₂ and/or SiO for the outermost layer thereof. When the article to be produced is an optical glass component for a touch panel, a part of the surface of the substrate (glass) may have a transparent electrode such as a thin film in which indium tin oxide (ITO), indium zinc oxide, or the like is used. The substrate, according to its specific configuration or the like, may have an insulating layer, an adhesive layer, a protecting layer, a decorated frame layer (I-CON), an atomizing film layer, a hard coating layer, a polarizing film, a phase difference film, a liquid crystal display module, or the like.

The shape of the substrate is not limited, and may be, for example, in the form of a plate, a film, or the like. The surface region of the substrate on which a surface-treating layer is to be formed may be at least a part of the substrate surface, and may be suitably determined according to the application, specific configuration, and the like of an article to be produced.

In one embodiment, the substrate, or at least the surface portion thereof, may be composed of a material originally having a hydroxyl group. Examples of the material include glass, as well as metal (in particular, base metal) where a natural oxidized film or a thermal oxidized film is formed on the surface, ceramics, and semiconductors. Alternatively, when the substrate has an insufficient amount of hydroxyl groups or when the substrate originally has no hydroxyl group as in resin and the like, a pre-treatment may be performed on the substrate to thereby introduce or increase hydroxyl groups on the surface of the substrate. Examples of such a pre-treatment include a plasma treatment (for example, corona discharge) and ion beam irradiation. The plasma treatment can be suitably utilized to not only introduce or increase hydroxyl groups on the substrate surface, but also clean the substrate surface (remove foreign matter and the like). Another example of such a pre-treatment is a method wherein a monolayer of a surface adsorbent having a carbon-carbon unsaturated bonding group is formed on the surface of the substrate by a LB method (a Langmuir-Blodgett method), a chemical adsorption method, or the like beforehand, and thereafter cleaving the unsaturated bond under an atmosphere containing oxygen, nitrogen, or the like.

In another embodiment, the substrate may be that of which at least the surface portion be composed of a material comprising other reactive group such as a silicone compound having one or more Si-H group or alkoxysilane.

In a preferred embodiment, the substrate is glass. The glass is preferably sapphire glass, soda-lime glass, alkali aluminosilicate glass, borosilicate glass, alkali-free glass, crystal glass, or quartz glass, particularly preferably chemically tempered soda-lime glass, chemically tempered alkali aluminosilicate glass, and chemically bonded borosilicate glass.

The article of the present disclosure can be produced by forming a layer of the surface-treating agent of the present disclosure on the surface of the substrate and post-treating this layer as necessary to thereby form a layer from the surface-treating agent of the present disclosure.

The layer of the surface-treating agent of the present disclosure can be formed by applying the above surface-treating agent on the surface of the substrate such that the surface-treating agent coats the surface. The coating method is not limited. For example, a wet coating method and a dry coating method can be used.

Examples of the wet coating method include dip coating, spin coating, flow coating, spray coating, roll coating, gravure coating, and similar methods.

Examples of the dry coating method include deposition (usually, vacuum deposition), sputtering, CVD, and similar methods. Specific examples of the deposition method (usually, a vacuum deposition method) include resistive heating, highfrequency heating using electron beam, microwave or the like, ion beam, and similar methods. Specific examples of the CVD method include plasma-CVD, optical CVD, thermal CVD, and similar methods.

Furthermore, coating by an atmospheric pressure plasma method can be performed.

When using the wet coating method, the surface-treating agent of the present disclosure can be applied to the substrate surface after being diluted with a solvent. From the viewpoint of the stability of the composition of the present disclosure and the volatility of solvents, the following solvents are preferably used: perfluoroaliphatic hydrocarbons having 5 to 12 carbon atoms (such as perfluorohexane, perfluoromethylcyclohexane, and perfluoro-1,3-dimethylcyclohexane); polyfluoroaromatic hydrocarbons (such as bis(trifluoromethyl)benzene); polyfluoroaliphatic hydrocarbons (such as C₆F₁₃CH₂CH₃ (such as Asahiklin (registered trademark) AC-6000 manufactured by Asahi Glass Co., Ltd.), and 1,1,2,2,3,3,4-heptafluorocyclopentane (such as Zeorora (registered trademark) H manufactured by Zeon Corporation)); alkyl perfluoroalkyl ethers (the perfluoroalkyl group and the alkyl group may be linear or branched) such as hydrofluoroether (HFE) (such as perfluoropropyl methyl ether (C₃F₇OCH₃) (such as Novec (trademark) 7000 manufactured by Sumitomo 3M Limited), perfluorobutyl methyl ether (C₄F₉OCH₃) (such as Novec (trademark) 7100 manufactured by Sumitomo 3M Limited), perfluorobutyl ethyl ether (C₄F₉OC₂H₅) (such as Novec (trademark) 7200 manufactured by Sumitomo 3M Limited), and perfluorohexyl methyl ether (C₂F₅CF(OCH₃)C₃F₇) (such as Novec (trademark) 7300 manufactured by Sumitomo 3M Limited), or CF₃CH₂OCF₂CHF₂ (such as Asahiklin (registered trademark) AE-3000 manufactured by Asahi Glass Co., Ltd.)). One of these solvents may be used singly, or two or more may be used as a mixture. In particular, hydrofluoroether is preferable, and perfluorobutyl methyl ether (C₄F₉OCH₃) and/or perfluorobutyl ethyl ether (C₄F₉OC₂H₅) is particularly preferable.

When using the dry coating method, the surface-treating agent of the present disclosure may be directly subjected to the dry coating method, or may be diluted with the above solvent before being subjected to the dry coating method.

A layer of the surface-treating agent is preferably formed such that the surface-treating agent of the present disclosure coexists in the layer with a catalyst for hydrolysis and dehydrative condensation. Conveniently, in the case of a wet coating method, the surface-treating agent of the present disclosure is diluted with a solvent, and then, immediately before application to the substrate surface, a catalyst may be added to the diluted solution of the surface-treating agent of the present disclosure. In the case of a dry coating method, the surface-treating agent of the present disclosure to which a catalyst has been added is directly used to a deposition (usually vacuum deposition) treatment, or a pellet-like material may be used to a deposition (usually vacuum deposition) treatment, wherein the pellets are obtained by impregnating a porous body of metal such as iron or copper with the surface-treating agent of the present disclosure to which the catalyst has been added.

Any suitable acid or base can be used as a catalyst. For example, acetic acid, formic acid, and trifluoroacetic acid can be used as the acid catalyst. For example, ammonia and organic amines can be used as the base catalyst.

The surface-treating layer contained in the article of the present disclosure has both high abrasion durability. The surface-treating layer may have not only high abrasion durability but also have, depending on the compositional features of the surface-treating agent used, water-repellency, oil-repellency, antifouling property (for example, preventing fouling such as fingerprints from adhering), waterproof property (preventing water from penetrating into electronic components and the like), surface lubricity (or lubricity, such as wiping property for fouling including fingerprints and the like and excellent tactile sensations to the fingers), chemical resistance, and the like, and may be suitably utilized as a functional thin film.

Therefore, the present disclosure further relates to an optical material having the surface-treating layer in the outermost layer.

The optical material preferably includes a wide variety of optical materials in addition to optical materials relating to displays and the like as exemplified below: for example, displays such as cathode ray tubes (CRTs; for example, PC monitors), liquid crystal displays, plasma displays, organic EL displays, inorganic thin-film EL dot matrix displays, rear projection displays, vacuum fluorescent displays (VFDs), field emission displays (FEDs); protective plates for such displays; and those obtained by performing an antireflection film treatment on their surfaces.

The article of the present disclosure may be, but is not limited to, an optical member. Examples of the optical member include lenses of glasses or the like; front surface protective plates, antireflection plates, polarizing plates, and anti-glare plates for displays such as PDPs and LCDs; touch panel sheets for devices such as mobile phones and personal digital assistants; disc surfaces of optical discs such as Blu-ray (registered trademark) discs, DVD discs, CD-Rs, and MOs; optical fibers; and display surfaces of watches and clocks.

The article of the present disclosure may be medical equipment or a medical material.

The thickness of the above layer is not limited. The thickness of the above layer in the case of an optical member is in the range of 1 to 50 nm, 1 to 30 nm, and preferably 1 to 15 nm, from the viewpoint of optical performance, abrasion durability, and antifouling property.

The article of the present disclosure has been described in detail above. The article of the present disclosure, the method for producing the article, and the like are not limited to those exemplified above.

### Examples

Hereinafter, an article of the present disclosure will be described in Examples, but the present disclosure is not limited to the following Examples. In the Examples, the occurrence order of the repeating units constituting fluoropolyether is not limited, and all chemical formulae shown below indicate average compositional features.

The following compounds were used as the fluoropolyether group-containing silane compound and the amide compound.

### · Fluoropolyether group-containing silane compound

A:

   CF₃O(CF₂O)k(CF₂CF₂O)l(CF₂CF₂CF₂O)m(CF₂CF₂CF₂CF₂O)nCF₂CONHCH₂C(CH₂CH₂CH₂Si(OCH₃)₃)₃
B:

   CF₃O(CF₂O)k(CF₂CF₂O)l(CF₂CF₂CF₂O)m(CF₂CF₂CF₂CF₂O)nCF₂CONHCH₂CH(CH₂CH₂CH₂Si(OCH₃)₃)₂
C:

   CF₃O(CF₂O)k(CF₂CF₂O)l(CF₂CF₂CF₂O)m(CF₂CF₂CF₂CF₂O)nCF₂CONHCH₂CH₂CH₂SiCH₃(CH₂CH₂CH₂Si(OCH₃)₃)₂
D:

   CF₃O(CF₂O)k(CF₂CF₂O)l(CF₂CF₂CF₂O)m(CF₂CF₂CF₂CF₂O)nC(OCH₂CH₂O)₂CH₃(CH₂CH₂CH₂Si(OCH₃)₃)₂
E:

   F(CF₂CF₂CF₂O)oCF₂CF₂(CH₂CHSi(OCH₃)₃)H

In the formula, k is 36, l is 22, m is 0.6, n is 0.2, and o is 28.

### · Amide compound

a: tetramethylurea
b: N-ethylacetamide
c: N-methylpropionamide
d: N,N-dimethylpropionamide
e: 1,3-dimethyl-3,4,5,6-tetrahydro-2(1H)-pyrimidinone
f: N,N-dimethylacetoacetamide
g: 2-pyrrolidone
h: 1-methyl-2-pyrrolidone
i: 3-methoxy-N,N-dimethylpropanamide
j: N,N-dimethylformamide
k: 3-butoxy-N,N-dimethylpropanamide
l: 1-ethyl-2-pyrrolidone
m: 1-octyl-2-pyrrolidone
n: N,N-dimethylacetamide

### · Solvent

Novec (R) 7200 (manufactured by 3M Japan Limited)

### · Compatibilizing agent

α: 2,2,3,3,3-pentafluoro-1-propanol
β: 2,2,2-trifluoroethanol
γ: dimethyl sulfoxide

### Examples 1 to 28 and Comparative Examples 1 to 7 (vacuum deposition method)

### (Preparation of surface-treating agent)

The surface-treating agents of Examples 1 to 32 and Comparative Examples 1 to 10 were prepared by adding the amide compound, the compatibilizing agent, and the like in the amounts shown in Table 1 below to Nor7200 solutions containing 20% by mass of the fluoropolyether group-containing silane compounds shown in Table 1 below.

### (Preparation of surface-treating layer)

The surface-treating agents prepared as described above (Examples 1 to 28 and Comparative Examples 1 to 7) were each vacuum-deposited on a chemically tempered glass ("Gorilla" glass, manufactured by Corning Incorporated, thickness 0.7 mm). The treatment conditions for the vacuum deposition were set to pressures of 3.0 × 10⁻³ Pa, and a silicon dioxide film was first formed on the surface of chemically tempered glass, followed by the deposition of 400 mg of a surface-treating agent to form a surface-treating layer.

### Examples 29 to 32 and Comparative Examples 8 to 10 (spin coating method)

### (Preparation of surface-treating agent)

The surface-treating agents of Examples 29 to 32 and Comparative Examples 8 to 10 were prepared by dissolving 0.12% by mass of the fluoropolyether group-containing silane compounds shown in Table 2 below, and the amide compound, the compatibilizing agent, and the like in the amounts shown in Table 2 below in Nor7200.

### (Preparation of surface-treating layer)

Onto a chemically tempered glass (50 mm × 50 mm) set on a spin coater, 1 g of the surface-treating agent obtained above was dropped, and then the glass was rotated for 30 seconds in 3000 rpm to form a coating layer of the surface-treating agent. Thereafter, the glass was heated using a ventilation oven to form a surface-treating layer on the chemically tempered glass.

### <Evaluation>

### (Eraser friction resistance test)

Using a rubbing tester (manufactured by Shinto Scientific Co., Ltd.), the water resistance contact angle was measured every 2,500 rubs under the following conditions, and the test was continued until it reached 10,000 rubs or until the angle became less than 100°, and the final number of times of abrasion at which the contact angle of 100° was maintained was compared. The test environment conditions were 25°C and a humidity of 40% RH. The results are shown in Tables 1 and 2 below.
Eraser: Raber Eraser (manufactured by Minoan)
Contact area: 6 mmcp
Moving distance (one way): 30 mm
Moving speed: 3,600 mm/min
Load: 1 kg/6 mmcp

**[Table 1]**

| | Fluorosilane compound | Amide compound | Amide compound concentration (wt%) | Compatibilizing agent | Compatibilizing agent concentration (wt%) | Eraser abrasion test result (times) |
|---|---|---|---|---|---|---|
| Example 1 | A | j | 1 | - | - | 5000 |
| Example 2 | A | j | 9 | - | - | 7500 |
| Example 3 | A | h | 1 | - | - | 6667 |
| Example 4 | A | h | 9 | - | - | 8125 |
| Example 5 | A | i | 1 | - | - | 12500 |
| Example 6 | A | i | 9 | - | - | 15000 |
| Example 7 | A | i | 9 | α | 9 | 10000 |
| Example 8 | A | i | 9 | β | 9 | 12500 |
| Example 9 | B | h | 0.5 | - | - | 11250 |
| Example 10 | B | h | 9 | - | - | 13750 |
| Example 11 | C | i | 9 | - | - | 8750 |
| Example 12 | D | i | 9 | - | - | 11250 |
| Example 13 | E | h | 9 | - | - | 10000 |
| Example 14 | A | a | 9 | - | - | 6250 |
| Example 15 | A | b | 9 | - | - | 5000 |
| Example 16 | A | c | 9 | - | - | 7500 |
| Example 17 | A | d | 9 | - | - | 6250 |
| Example 18 | A | e | 9 | - | - | 6250 |
| Example 19 | A | n | 9 | - | - | 6250 |
| Example 20 | A | g | 9 | - | - | 6250 |
| Example 21 | A | h | 9 | - | - | 8250 |
| Example 22 | A | i | 9 | - | - | 10000 |
| Example 23 | A | j | 9 | - | - | 7500 |
| Example 24 | A | k | 9 | - | - | 5000 |
| Example 25 | A | l | 9 | - | - | 10000 |
| Example 26 | A | m | 9 | - | - | 8750 |
| Example 27 | E | h | 9 | - | - | 15000 |
| Example 28 | E | i | 9 | - | - | 8750 |
| Comparative Example 1 | A | not added | - | - | - | 3750 |
| Comparative Example 2 | B | not added | - | - | - | 8750 |
| Comparative Example 3 | C | not added | - | - | - | 3750 |
| Comparative Example 4 | D | not added | - | - | - | 6250 |
| Comparative Example 5 | E | not added | - | - | - | <2500 |
| Comparative Example 6 | E | not added | - | - | - | <2500 |
| Comparative Example 7 | A | not added | - | γ | g | 3750 |

**[Table 2]**

| | Fluorosilane compound | Amide compound | Amide compound concentration (wt%) | Compatibilizing agent | Compatibilizing agent concentration (wt%) | Eraser abrasion test result (times) |
|---|---|---|---|---|---|---|
| Example 29 | A | n | 1 | - | - | 7500 |
| Example 30 | A | n | 1 | - | - | 12500 |
| Example 31 | A | n | 10 | - | - | 12500 |
| Example 32 | A | h | 1 | - | - | 15000 |
| Comparative Example 8 | A | not added | - | - | - | 2500 |
| Comparative Example 9 | A | not added | - | α | 1 | 3750 |
| Comparative Example 10 | A | not added | - | β | 1 | 2500 |

### (Stability test)

The intermolecular reactivity of the silane coupling site of the fluoropolyether group-containing silane compound was evaluated. To each of the solutions of Example 6 and Comparative Example 1, 9 equivalents of water relative to the fluoropolyether group-containing silane compound was added, followed by stirring. Thereafter, ²⁹Si-NMR was measured over time, and with respect to the silane coupling site, peak changes were observed in the peaks indicating the non-condensed state (Mn), peaks indicating that one of trialkoxys are condensed (Dn), and peaks indicating that two of trialkoxys are condensed (Tn). The results are shown in Figure 1.

From the above results, it was confirmed that the condensation of the surface-treating agent in Comparative Example 1 proceeded after 14 hours of water addition and further after 37 hours. On the other hand, in the surface-treating agent of Example 6, a large amount of non-condensed components remained even 36 hours after the addition of water, which confirmed that the intermolecular condensation between the fluoropolyether group-containing silane compounds was suppressed.

### Industrial Applicability

The article of the present disclosure can be suitably used in various applications, for example, as an optical member of a touch panel or the like.

## Claims

1. A surface-treating agent comprising a fluoropolyether group-containing silane compound and an amide compound, wherein the amide compound is contained in an amount of 0.5% by mass or more based on a total amount of the surface-treating agent.

2. The surface-treating agent according to claim 1, wherein the fluoropolyether group-containing silane compound is at least one fluoropolyether group-containing silane compound represented by the following formula (1) or (2):
R^{F1}_{α}-X^{A}-R^{Si}β (1)
R^{Si}_{γ}-X^{A}-R^{F2}-X^{A}-R^{Si}_{γ} (2)
wherein
R^{F1} is each independently at each occurrence Rf¹-R^{F}-O_{q}-;
R^{F2} is -Rf²ₚ-R^{F}-O_{q}-;
Rf¹ is each independently at each occurrence a C₁₋₁₆ alkyl group optionally substituted with one or more fluorine atoms;
Rf² is a C₁₋₆ alkylene group optionally substituted with one or more fluorine atoms;
R^{F} is each independently at each occurrence a divalent fluoropolyether group;
p is 0 or 1;
q is each independently at each occurrence 0 or 1;
R^{Si} is each independently at each occurrence a monovalent group containing a Si atom to which a hydroxyl group, a hydrolyzable group, a hydrogen atom or a monovalent organic group is bonded;
at least one R^{Si} is a monovalent group containing a Si atom to which a hydroxyl group or a hydrolyzable group is bonded;
X^{A} is each independently a single bond or a di- to decavalent organic group;
α is an integer of 1 to 9;
β is an integer of 1 to 9; and
γ is each independently an integer of 1 to 9.

3. The surface-treating agent according to claim 2, wherein Rf¹ is each independently at each occurrence a C₁₋₁₆ perfluoroalkyl group; and
Rf² is each independently at each occurrence a C₁₋₆ perfluoroalkylene group.

4. The surface-treating agent according to claim 2 or 3, wherein R^{F} is each independently at each occurrence a group represented by the formula:
-(OC₆F₁₂)ₐ-(OC₅F₁₀)_{b}-(OC₄F₈)_{c}-(OC₃R^{Fa}₆)_{d}-(OC₂F₄)ₑ- (OCF₂)_{f}-
wherein R^{Fa} is each independently at each occurrence a hydrogen atom, a fluorine atom, or a chlorine atom; and
a, b, c, d, e, and f are each independently an integer of 0 to 200, the sum of a, b, c, d, e, and f is 1 or more, the occurrence order of the respective repeating units enclosed in parentheses provided with a, b, c, d, e, or f is not limited in the formula, provided that when all R^{Fa} are a hydrogen atom or a chlorine atom, at least one of a, b, c, e, and f is 1 or more.

5. The surface-treating agent according to claim 4, wherein R^{Fa} is a fluorine atom.

6. The surface-treating agent according to any one of claims 2 to 5, wherein R^{F} is each independently at each occurrence a group represented by the following formula (f1), (f2), (f3), (f4), or (f5):
-(OC₃F₆)_{d}-(OC₂F₄)ₑ- (f1)
wherein d is an integer of 1 to 200, and e is 0 or 1;
-(OC₄F₈)_{c}-(OC₃F₆)_{d}-(OC₂F₄)ₑ-(OCF₂)_{f}- (f2)
wherein c and d are each independently an integer of 0 to 30;
e and f are each independently an integer of 1 to 200;
the sum of c, d, e, and f is an integer of 10 to 200; and
the occurrence order of the respective repeating units enclosed in parentheses provided with the subscript c, d, e, or f is not limited in the formula;
-(R⁶-R⁷)_{g}- (f3)
wherein R⁶ is OCF₂ or OC₂F₄;
R⁷ is a group selected from OC₂F₄, OC₃F₆, OC₄F₈, OC₅F₁₀, and OC₆F₁₂, or is a combination of two or three groups selected from these groups; and
g is an integer of 2 to 100;
-(OC₆F₁₂)ₐ-(OC₅F₁₀)_{b}-(OC₄F₈)_{c}-(OC₃F₆)_{d}-(OC₂F₄)ₑ-(OCF₂)_{f}- (f4)
wherein e is an integer of 1 or more and 200 or less, a, b, c, d, and f are each independently an integer of 0 or more and 200 or less, and the occurrence order of the respective repeating units enclosed in parentheses provided with a, b, c, d, e or f is not limited in the formula; and
-(OC₆F₁₂)ₐ-(OC₅F₁₀)_{b}-(OC₄F₈)_{c}-(OC₃F₆)_{d}-(OC₂F₄)ₑ-(OCF₂)_{f}- (f5)
wherein f is an integer of 1 or more and 200 or less, a, b, c, d, and e are each independently an integer of 0 or more and 200 or less, and the occurrence order of the respective repeating units enclosed in parentheses provided with a, b, c, d, e or f is not limited in the formula.

7. The surface-treating agent according to any one of claims 2 to 6, wherein R^{Si} is a group represented by the following formula (S1), (S2), (S3), (S4), or (S5): 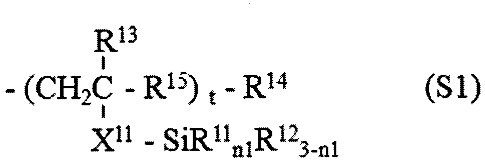
- SiR¹¹ₙ₁R¹²₃₋ₙ₁ (S2)
- SiR^{a1}ₖ₁R^{b1}₁₁R^{c1}ₘ₁ (S3)
- CR^{d1}ₖ₂R^{e1}₁₂R^{f1}ₘ₂ (S4)
- NR^{g1}R^{h1} (S3)
wherein
R¹¹ is each independently at each occurrence a hydroxyl group or a hydrolyzable group;
R¹² is each independently at each occurrence a hydrogen atom or a monovalent organic group;
n1 is each independently an integer of 0 to 3 for each (SiR¹¹ₙ₁R¹²₃₋ₙ₁) unit;
X¹¹ is each independently at each occurrence a single bond or a divalent organic group;
R¹³ is each independently at each occurrence a hydrogen atom or a monovalent organic group;
t is each independently at each occurrence an integer of 2 or more;
R¹⁴ is each independently at each occurrence a hydrogen atom, a halogen atom, or -X¹¹-SiR¹¹ₙ₁R¹²₃₋ₙ₁;
R^{a1} is each independently at each occurrence -Z¹-SiR²¹ₚ₁R²²_{q1}R²³ᵣ₁;
Z¹ is each independently at each occurrence an oxygen atom or a divalent organic group;
R²¹ is each independently at each occurrence -Z^{1'}-SiR^{21'}_{p1'}R^{22'}_{q1'}R^{23'}_{r1'};
R²² is each independently at each occurrence a hydroxyl group or a hydrolyzable group;
R²³ is each independently at each occurrence a hydrogen atom or a monovalent organic group;
p1 is each independently at each occurrence an integer of 0 to 3;
q1 is each independently at each occurrence an integer of 0 to 3;
r1 is each independently at each occurrence an integer of 0 to 3;
the sum of p1, q1, and r1 is 3;
Z^{1'} is each independently at each occurrence an oxygen atom or a divalent organic group;
R^{21'} is each independently at each occurrence -Z^{1"}-SiR^{22"}_{q1"}R^{23"}_{r1"} ;
R^{22'} is each independently at each occurrence a hydroxyl group or a hydrolyzable group;
R^{23'} is each independently at each occurrence a hydrogen atom or a monovalent organic group;
p1' is each independently at each occurrence an integer of 0 to 3;
q1' is each independently at each occurrence an integer of 0 to 3;
r1' is each independently at each occurrence an integer of 0 to 3;
the sum of p1', q1', and r1' is 3;
Z^{1"} is each independently at each occurrence an oxygen atom or a divalent organic group;
R^{22"} is each independently at each occurrence a hydroxyl group or a hydrolyzable group;
R^{23"} is each independently at each occurrence a hydrogen atom or a monovalent organic group;
q1" is each independently at each occurrence an integer of 0 to 3;
r1" is each independently at each occurrence an integer of 0 to 3;
the sum of q1" and r1" is 3;
R^{b1} is each independently at each occurrence a hydroxyl group or a hydrolyzable group;
R^{c1} is each independently at each occurrence a hydrogen atom or a monovalent organic group;
k1 is each independently at each occurrence an integer of 0 to 3;
l1 is each independently at each occurrence an integer of 0 to 3;
m1 is each independently at each occurrence an integer of 0 to 3;
the sum of k1, l1, and m1 is 3;
R^{d1} is each independently at each occurrence -Z²-CR³¹ₚ₂R³²_{q2}R³³ᵣ₂;
Z² is each independently at each occurrence a single bond, an oxygen atom, or a divalent organic group;
R³¹ is each independently at each occurrence -Z^{2'}-CR^{32'}q_{2'}R^{33'}_{r2'};
R³² is each independently at each occurrence -Z³-SiR³⁴ₙ₂R³⁵₃-ₙ₂;
R³³ is each independently at each occurrence a hydrogen atom, a hydroxyl group, or a monovalent organic group;
p2 is each independently at each occurrence an integer of 0 to 3;
q2 is each independently at each occurrence an integer of 0 to 3;
r2 is each independently at each occurrence an integer of 0 to 3;
the sum of p2, q2, and r2 is 3;
Z^{2'} is each independently at each occurrence a single bond, an oxygen atom, or a divalent organic group;
R^{32'} is each independently at each occurrence -Z³-SiR³⁴ₙ₂R³⁵₃₋ₙ₂;
R^{33'} is each independently at each occurrence a hydrogen atom, a hydroxyl group, or a monovalent organic group;
q2' is each independently at each occurrence an integer of 0 to 3;
r2' is each independently at each occurrence an integer of 0 to 3;
the sum of q2' and r2' is 3;
Z³ is each independently at each occurrence a single bond, an oxygen atom, or a divalent organic group;
R³⁴ is each independently at each occurrence a hydroxyl group or a hydrolyzable group;
R³⁵ is each independently at each occurrence a hydrogen atom or a monovalent organic group;
n2 is each independently at each occurrence an integer of 0 to 3;
R^{e1} is each independently at each occurrence -Z³-SiR³⁴ₙ₂R³⁵₃₋ₙ₂;
R^{f1} is each independently at each occurrence a hydrogen atom, a hydroxyl group, or a monovalent organic group;
k2 is each independently at each occurrence an integer of 0 to 3;
l2 is each independently at each occurrence an integer of 0 to 3;
m2 is each independently at each occurrence an integer of 0 to 3;
the sum of k2, l2, and m2 is 3;
R^{g1} and R^{h1} are each independently at each occurrence - Z⁴-SiR¹¹ₙ₁R¹²₃₋ₙ₁, -Z⁴-SiR^{a1}ₖ₁R^{b1}₁₁R^{c1}ₘ₁, or -Z⁴-CR^{d1}ₖ₂R^{e1}₁₂R^{f1}ₘ₂; and
Z⁴ is each independently at each occurrence a single bond, an oxygen atom, or a divalent organic group,
provided that in the formulae (S1), (S2), (S3), (S4), and (S5), at least one Si atom to which a hydroxyl group or a hydrolyzable group is bonded is present.

8. The surface-treating agent according to any one of claims 2 to 7, wherein each of α, β and γ is 1.

9. The surface-treating agent according to claim 7 or 8, wherein the group represented by the formula (S1) is a group represented by the following formula (S1-b): 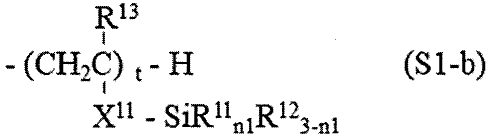 wherein R¹¹, R¹², R¹³, X¹¹, n1, and t have the same definition as described for the formula (S1).

10. The surface-treating agent according to any one of claims 1 to 9, wherein a content of the amide compound is 0.5 to 10.0% by mass based on the total amount of the surface-treating agent.

11. The surface-treating agent according to any one of claims 1 to 10, wherein a boiling point of the amide compound under atmospheric pressure is 150 to 300°C.

12. The surface-treating agent according to any one of claims 1 to 11, wherein the amide compound is an amide compound represented by the following formula (A):
NR⁶¹R⁶²-COR⁶³ (A)
wherein
R⁶¹ is a hydrogen atom or a C₁₋₁₀ alkyl group;
R⁶² is a C₁₋₁₀ alkyl group;
R⁶³ is a hydrogen atom, a C₁₋₁₀ alkyl group, NR⁶⁵₂, or - R⁶⁶ₓ-R⁶⁷_{y}-R⁶⁸;
or, R⁶² and R⁶³ are bonded to each other to form -R⁶²-R⁶³-, wherein -R⁶²-R⁶³- is a C₃₋₄ alkylene group or -C₂₋₃ alkylene-NR⁶⁵-;
R⁶⁵ is each independently a hydrogen atom or a C₁₋₁₀ alkyl group;
R⁶⁶ is each independently at each occurrence a C₁₋₆ alkylene group;
R⁶⁷ is an oxygen atom or CO;
R⁶⁸ is a C₁₋₁₀ alkyl group;
x is an integer of 1 to 6; and
y is an integer of 1 to 6,
with the proviso that each occurrence order of R⁶⁶ and R⁶⁷ in -R⁶⁶ₓ-R⁶⁷_{y}-R⁶⁸ is not limited.

13. The surface-treating agent according to claim 12, wherein R⁶³ is -R⁶⁶ₓ-R⁶⁷_{y}-R⁶⁸.

14. The surface-treating agent according to claim 12, wherein R⁶³ is -R⁶⁶-R⁶⁷-R⁶⁸.

15. The surface-treating agent according to claim 12, wherein R⁶² and R⁶³ are bonded to each other to form -R⁶²-R⁶³-, wherein -R⁶²-R⁶³- is a C₃₋₄ alkylene group.

16. The surface-treating agent according to any one of claims 1 to 15, further comprising one or more other components selected from a fluorine-containing oil, a silicone oil, and a catalyst.

17. The surface-treating agent according to any one of claims 1 to 16, further comprising a solvent.

18. The surface-treating agent according to any one of claims 1 to 17, which is used as an antifouling coating agent or a water-proof coating agent.

19. A pellet comprising the surface-treating agent according to any one of claims 1 to 18.

20. An article comprising a substrate and a layer on the substrate, the layer being formed of the surface-treating agent according to any one of claims 1 to 18.

21. The article according to claim 20, wherein the substrate is a glass substrate.

22. The article according to claim 20, which is an optical member.
